# EUROPEAN PATENT APPLICATION

(11) **EP 3 343 657 A1**
(43) Date of publication of application: **04.07.2018**
(21) Application number: 16839274.4
(22) Date of filing: 23.08.2016
(51) Int. Cl.: H01L 51/50, C09K 11/06

(54) **ORGANIC ELECTROLUMINESCENT ELEMENT**

(30) Priority: 27.08.2015 JP 2015168233
(71) Applicant: Hodogaya Chemical Co., Ltd., Tokyo 104-0028 (JP)
(72) Inventor: KASE, Kouki, Tokyo 104-0028 (JP); NAGAOKA, Makoto, Tokyo 104-0028 (JP); SURUGA, Kazuyuki, Tokyo 104-0028 (JP)
(74) Representative: Müller-Boré & Partner Patentanwälte PartG mbB
(86) International application number: PCT/JP2016/074511
(87) International publication number: WO 2017/033927

(57) **Abstract**

An object of the present invention is to provide an organic EL device having high efficiency, low driving voltage and a long lifetime, by combining various materials for an organic EL device, which are excellent, as materials for an organic EL device having high efficiency and high durability, in hole and electron injection/transport performances, electron blocking ability, stability in a thin-film state and durability, so as to allow the respective materials to effectively reveal their characteristics.

An organic electroluminescent device comprising at least an anode, a hole transport layer, a light emitting layer, an electron transport layer, and a cathode in this order, wherein the hole transport layer comprises an arylamine compound of the following general formula (1).

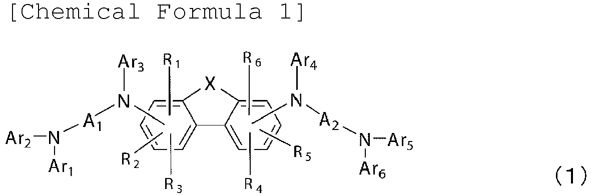

## Description

### Technical Field

The present invention relates to an organic electroluminescent device which is a preferred self-luminous device for various display devices. Specifically, this invention relates to organic electroluminescent devices (hereinafter referred to as organic EL devices) using specific arylamine compounds (and specific compounds having an anthracene ring structure).

### Background Art

The organic EL device is a self-luminous device and has been actively studied for their brighter, superior visibility and the ability to display clearer images in comparison with liquid crystal devices.

In 1987, C. W. Tang and colleagues at Eastman Kodak developed a laminated structure device using materials assigned with different roles, realizing practical applications of an organic EL device with organic materials. These researchers laminated an electron-transporting phosphor and a hole-transporting organic substance, and injected both charges into a phosphor layer to cause emission in order to obtain a high luminance of 1,000 cd/m² or more at a voltage of 10 V or less (refer to PTLs 1 and 2, for example).

To date, various improvements have been made for practical applications of the organic EL device. Various roles of the laminated structure are further subdivided to provide an electroluminescence device that includes an anode, a hole injection layer, a hole transport layer, a light emitting layer, an electron transport layer, an electron injection layer, and a cathode successively formed on a substrate, and high efficiency and durability have been achieved by the electroluminescence device (refer to NPL 1, for example).

Further, there have been attempts to use triplet excitons for further improvements of luminous efficiency, and the use of a phosphorescence-emitting compound has been examined (refer to NPL 2, for example).

Devices that use light emission caused by thermally activated delayed fluorescence (TADF) have also been developed. In 2011, Adachi et al. at Kyushu University, National University Corporation realized 5.3% external quantum efficiency with a device using a thermally activated delayed fluorescent material (refer to NPL 3, for example).

The light emitting layer can be also fabricated by doping a charge-transporting compound generally called a host material, with a fluorescent-emitting compound, a phosphorescence-emitting compound, or a delayed fluorescent-emitting material. As described in the NPLs 1 and 2, the selection of organic materials in an organic EL device greatly influences various device characteristics such as efficiency and durability.

In an organic EL device, charges injected from both electrodes recombine in a light emitting layer to cause emission. What is important here is how efficiently the hole and electron charges are transferred to the light emitting layer in order to form a device having excellent carrier balance. The probability of hole-electron recombination can be improved by improving hole injectability and electron blocking performance of blocking injected electrons from the cathode, and high luminous efficiency can be obtained by confining excitons generated in the light emitting layer. The role of a hole transport material is therefore important, and there is a need for a hole transport material that has high hole injectability, high hole mobility, high electron blocking performance, and high durability to electrons.

Heat resistance and amorphousness of the materials are also important with respect to the lifetime of the device. The materials with low heat resistance cause thermal decomposition even at a low temperature by heat generated during the drive of the device, which leads to the deterioration of the materials. The materials with low amorphousness cause crystallization of a thin film even in a short time and lead to the deterioration of the device. The materials in use are therefore required to have characteristics of high heat resistance and satisfactory amorphousness.

N,N'-diphenyl-N,N'-di(α-naphthyl)benzidine (NPD) and various aromatic amine derivatives are known as the hole transport materials used for the organic EL device (refer to PTLs 1 and 2, for example). Although NPD has desirable hole transportability, its glass transition point (Tg), which is an index of heat resistance, is as low as 96°C, which causes the degradation of device characteristics by crystallization under a high-temperature condition (refer to NPL 4, for example). The aromatic amine derivatives described in the PTLs 1 and 2 include a compound known to have an excellent hole mobility of 10⁻³ cm²/Vs or higher. However, since the compound is insufficient in terms of electron blocking performance, some of the electrons pass through the light emitting layer, and improvements in luminous efficiency cannot be expected. For such a reason, a material with higher electron blocking performance, a more stable thin-film state and higher heat resistance is needed for higher efficiency.

Aromatic tertiary amine compounds of the following formula (for example, Compound A) are proposed as compounds improved in the characteristics such as heat resistance, hole injectability, hole transportability or electron blocking performance (refer to PTL 3, for example).

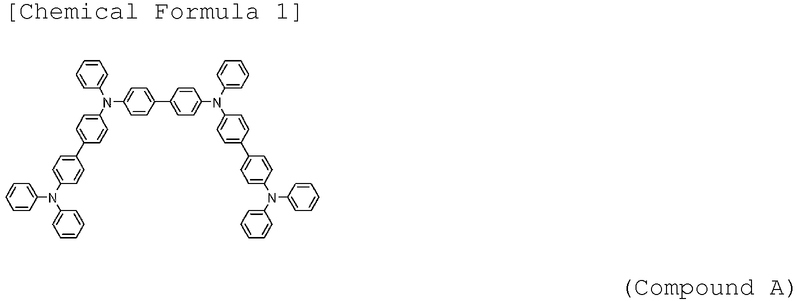

However, while the devices using these compounds for the hole injection layer, the hole transport layer or the electron blocking layer have been improved in heat resistance, luminous efficiency and the like, the improvements are still insufficient. Further, it cannot be said to have a sufficiently low driving voltage and sufficient current efficiency, and there is a problem also in amorphousness. Further improvements of a low driving voltage and luminous efficiency while increasing amorphousness are therefore needed.

### Citation List

### Patent Literature

PTL 1: JP-A-8-48656
PTL 2: Japanese Patent No. 3194657
PTL 3: WO2012/117973
PTL 4: WO2011/059000
PTL 5: WO2003/060956
PTL 6: KR-A-2013-060157

### Non Patent Literature

NPL 1: The Japan Society of Applied Physics, 9th Lecture Preprints, pp. 55 to 61 (2001)
NPL 2: The Japan Society of Applied Physics, 9th Lecture Preprints, pp. 23 to 31 (2001)
NPL 3: Appl. Phys. Let., 98, 083302 (2011)
NPL 4: Organic EL Symposium, the 3rd Regular presentation Preprints, pp. 13 to 14 (2006)

### Summary of Invention

### Technical Problem

An object of the present invention is to provide an organic EL device having high efficiency, low driving voltage and a long lifetime, by combining various materials for an organic EL device, which are excellent, as materials for an organic EL device having high efficiency and high durability, in hole and electron injection/transport performances, electron blocking ability, stability in a thin-film state and durability, so as to allow the respective materials to effectively reveal their characteristics.

Physical properties of the organic compound to be provided by the present invention include (1) good hole injection characteristics, (2) large hole mobility, (3) excellent electron blocking ability, (4) stability in a thin-film state, and (5) excellent heat resistance. Physical properties of the organic EL device to be provided by the present invention include (1) high luminous efficiency and high power efficiency, (2) low turn on voltage, (3) low actual driving voltage, and (4) a long lifetime.

### Solution to Problem

To achieve the above object, the present inventors have noted that an arylamine material is excellent in hole injection and transport abilities, stability as a thin film and durability, and compounds having an anthracene ring structure are excellent in electron injection and transport abilities, stability as a thin film and durability. They have selected specific arylamine compounds and specific compounds having an anthracene ring structure such that holes and electrons can be efficiently injected and transported into a light emitting layer, and have produced various organic EL devices by combining a hole transport material and an electron transport material in good carrier balance. Then, they have intensively conducted characteristic evaluations of the devices. As a result, they have completed the present invention.

Specifically, according to the present invention, the following organic EL devices are provided.
1) An organic EL device comprising at least an anode, a hole transport layer, a light emitting layer, an electron transport layer, and a cathode in this order, wherein the hole transport layer comprises an arylamine compound of the following general formula (1). 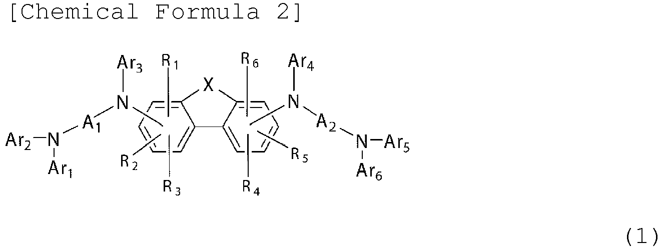
   In the formula, Ar₁ to Ar₆ may be the same or different, and represent a substituted or unsubstituted aromatic hydrocarbon group, a substituted or unsubstituted aromatic heterocyclic group, or a substituted or unsubstituted condensed polycyclic aromatic group. A₁ and A₂ may be the same or different, and represent a divalent group of a substituted or unsubstituted aromatic hydrocarbon, a divalent group of a substituted or unsubstituted aromatic heterocyclic ring, or a divalent group of a substituted or unsubstituted condensed polycyclic aromatic. R₁ to R₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy. X represents an oxygen atom or a sulfur atom.
2) The organic EL device of 1), wherein the arylamine compound is an arylamine compound of the following general formula (1a). 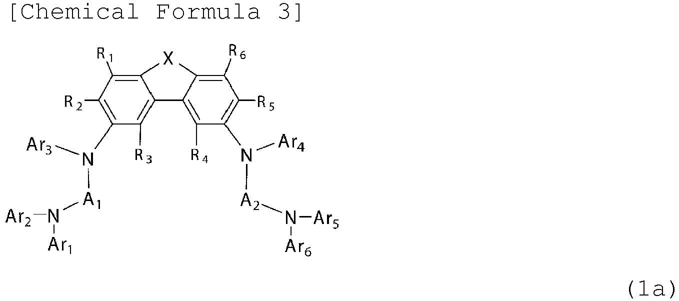
   In the formula, Ar₁ to Ar₆ may be the same or different, and represent a substituted or unsubstituted aromatic hydrocarbon group, a substituted or unsubstituted aromatic heterocyclic group, or a substituted or unsubstituted condensed polycyclic aromatic group. A₁ and A₂ may be the same or different, and represent a divalent group of a substituted or unsubstituted aromatic hydrocarbon, a divalent group of a substituted or unsubstituted aromatic heterocyclic ring, or a divalent group of a substituted or unsubstituted condensed polycyclic aromatic. R₁ to R₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy. X represents an oxygen atom or a sulfur atom.
3) The organic EL device of 1), wherein the arylamine compound is an arylamine compound of the following general formula (1b). 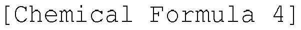 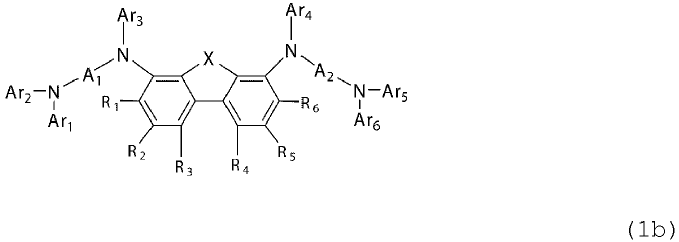
   In the formula, Ar₁ to Ar₆ may be the same or different, and represent a substituted or unsubstituted aromatic hydrocarbon group, a substituted or unsubstituted aromatic heterocyclic group, or a substituted or unsubstituted condensed polycyclic aromatic group. A₁ and A₂ may be the same or different, and represent a divalent group of a substituted or unsubstituted aromatic hydrocarbon, a divalent group of a substituted or unsubstituted aromatic heterocyclic ring, or a divalent group of a substituted or unsubstituted condensed polycyclic aromatic. R₁ to R₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy. X represents an oxygen atom or a sulfur atom.
4) The organic EL device of any one of 1) to 3), wherein the electron transport layer comprises a compound of the following general formula (2) having an anthracene ring structure. 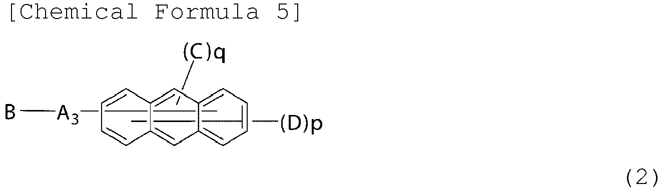
   In the formula, A₃ represents a divalent group of a substituted or unsubstituted aromatic hydrocarbon, a divalent group of a substituted or unsubstituted aromatic heterocyclic ring, a divalent group of a substituted or unsubstituted condensed polycyclic aromatic, or a single bond. B represents a substituted or unsubstituted aromatic heterocyclic group. C represents a substituted or unsubstituted aromatic hydrocarbon group, a substituted or unsubstituted aromatic heterocyclic group, or a substituted or unsubstituted condensed polycyclic aromatic group. D may be the same or different, and represents a hydrogen atom, a deuterium atom, a fluorine atom, a chlorine atom, cyano, trifluoromethyl, linear or branched alkyl of 1 to 6 carbon atoms, a substituted or unsubstituted aromatic hydrocarbon group, a substituted or unsubstituted aromatic heterocyclic group, or a substituted or unsubstituted condensed polycyclic aromatic group. p represents 7 or 8, and q represents 1 or 2 while maintaining a relationship that a sum of p and q is 9.
5) The organic EL device of 4), wherein the compound having an anthracene ring structure is a compound of the following general formula (2a) having an anthracene ring structure. 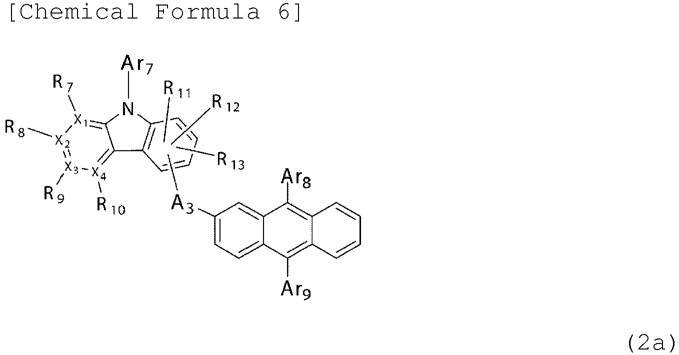
   In the formula, A₃ represents a divalent group of a substituted or unsubstituted aromatic hydrocarbon, a divalent group of a substituted or unsubstituted aromatic heterocyclic ring, a divalent group of a substituted or unsubstituted condensed polycyclic aromatic, or a single bond. Ar₇, Ar₈, and Ar₉ may be the same or different, and represent a substituted or unsubstituted aromatic hydrocarbon group, a substituted or unsubstituted aromatic heterocyclic group, or a substituted or unsubstituted condensed polycyclic aromatic group. R₇ to R₁₃ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy, and may bind to each other via a single bond, substituted or unsubstituted methylene, an oxygen atom, or a sulfur atom to form a ring. X₁, X₂, X₃, and X₄ represent a carbon atom or a nitrogen atom, where only one of X₁, X₂, X₃, and X₄ is a nitrogen atom, and, in this case, the nitrogen atom does not have the hydrogen atom or substituent for R₇ to R₁₀.
6) The organic EL device of 4), wherein the compound having an anthracene ring structure is a compound of the following general formula (2b) having an anthracene ring structure. 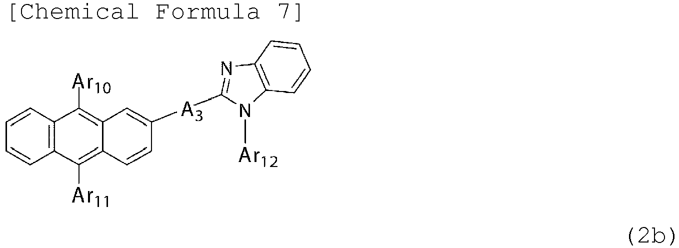
   In the formula, A₃ represents a divalent group of a substituted or unsubstituted aromatic hydrocarbon, a divalent group of a substituted or unsubstituted aromatic heterocyclic ring, a divalent group of a substituted or unsubstituted condensed polycyclic aromatic, or a single bond. Ar₁₀, Ar₁₁, and Ar₁₂ may be the same or different, and represent a substituted or unsubstituted aromatic hydrocarbon group, a substituted or unsubstituted aromatic heterocyclic group, or a substituted or unsubstituted condensed polycyclic aromatic group.
7) The organic EL device of 4), wherein the compound having an anthracene ring structure is a compound of the following general formula (2c) having an anthracene ring structure. 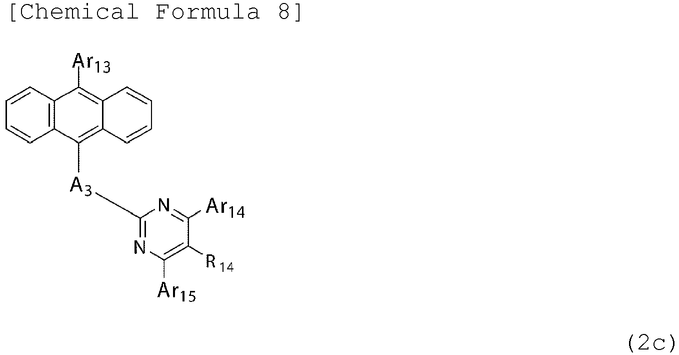
   In the formula, A₃ represents a divalent group of a substituted or unsubstituted aromatic hydrocarbon, a divalent group of a substituted or unsubstituted aromatic heterocyclic ring, a divalent group of a substituted or unsubstituted condensed polycyclic aromatic, or a single bond. Ar₁₃, Ar₁₄, and Ar₁₅ may be the same or different, and represent a substituted or unsubstituted aromatic hydrocarbon group, a substituted or unsubstituted aromatic heterocyclic group, or a substituted or unsubstituted condensed polycyclic aromatic group. R₁₄ represents a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy.
8) The organic EL device of any one of 1) to 7), wherein the light emitting layer includes a blue light emitting dopant.
9) The organic EL device of 8), wherein the light emitting layer includes a blue light emitting dopant which is a pyrene derivative.
10) The organic EL device of any one of 1) to 9), wherein the light emitting layer includes an anthracene derivative.
11) The organic EL device of 10), wherein the light emitting layer includes a host material which is an anthracene derivative.
12) An organic EL device comprising an anode, a hole transport layer, an electron blocking layer, a light emitting layer, an electron transport layer, and a cathode in this order, wherein the electron blocking layer comprises an arylamine compound of the following general formula (1). 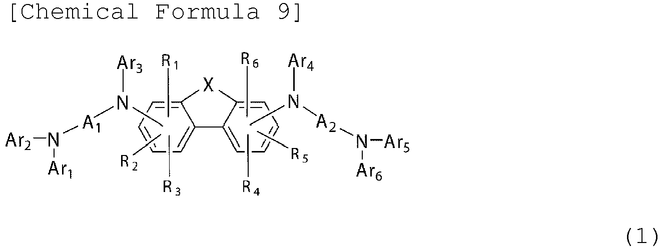
   In the formula, Ar₁ to Ar₆ may be the same or different, and represent a substituted or unsubstituted aromatic hydrocarbon group, a substituted or unsubstituted aromatic heterocyclic group, or a substituted or unsubstituted condensed polycyclic aromatic group. A₁ and A₂ may be the same or different, and represent a divalent group of a substituted or unsubstituted aromatic hydrocarbon, a divalent group of a substituted or unsubstituted aromatic heterocyclic ring, or a divalent group of a substituted or unsubstituted condensed polycyclic aromatic. R₁ to R₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy. X represents an oxygen atom or a sulfur atom.
13) An organic EL device comprising an anode, a hole injection layer, a hole transport layer, a light emitting layer, an electron transport layer, and a cathode in this order, wherein the hole injection layer comprises an arylamine compound of the following general formula (1). 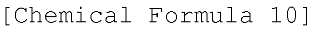 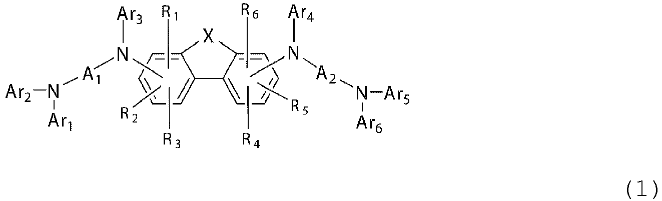
   In the formula, Ar₁ to Ar₆ may be the same or different, and represent a substituted or unsubstituted aromatic hydrocarbon group, a substituted or unsubstituted aromatic heterocyclic group, or a substituted or unsubstituted condensed polycyclic aromatic group. A₁ and A₂ may be the same or different, and represent a divalent group of a substituted or unsubstituted aromatic hydrocarbon, a divalent group of a substituted or unsubstituted aromatic heterocyclic ring, or a divalent group of a substituted or unsubstituted condensed polycyclic aromatic. R₁ to R₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy. X represents an oxygen atom or a sulfur atom.
14) An organic EL device comprising an anode, a hole transport layer, a light emitting layer, an electron transport layer, and a cathode in this order, wherein the light emitting layer comprises an arylamine compound of the following general formula (1). 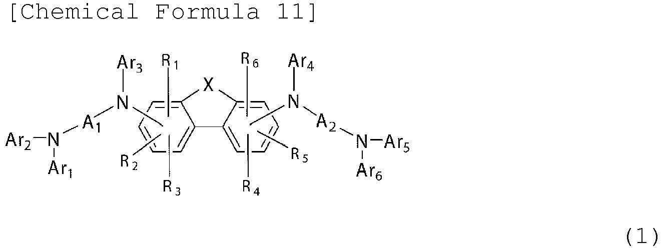
   In the formula, Ar₁ to Ar₆ may be the same or different, and represent a substituted or unsubstituted aromatic hydrocarbon group, a substituted or unsubstituted aromatic heterocyclic group, or a substituted or unsubstituted condensed polycyclic aromatic group. A₁ and A₂ may be the same or different, and represent a divalent group of a substituted or unsubstituted aromatic hydrocarbon, a divalent group of a substituted or unsubstituted aromatic heterocyclic ring, or a divalent group of a substituted or unsubstituted condensed polycyclic aromatic. R₁ to R₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy. X represents an oxygen atom or a sulfur atom.

Specific examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₆ in the general formula (1), the general formula (1a), and the general formula (1b) include a phenyl group, a biphenylyl group, a terphenylyl group, a naphthyl group, an anthracenyl group, a phenanthrenyl group, a fluorenyl group, an indenyl group, a pyrenyl group, a perylenyl group, a fluoranthenyl group, a triphenylenyl group, a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, a benzoxazolyl group, a benzothiazolyl group, a quinoxalinyl group, a benzoimidazolyl group, a pyrazolyl group, a dibenzofuranyl group, a dibenzothienyl group, a naphthyridinyl group, a phenanthrolinyl group, an acridinyl group, and a carbolinyl group.

Specific examples of the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a), and the general formula (1b) include a deuterium atom, cyano, nitro; halogen atoms, such as a fluorine atom, a chlorine atom, a bromine atom, and an iodine atom; linear or branched alkyls of 1 to 6 carbon atoms, such as methyl, ethyl, n-propyl, isopropyl, n-butyl, isobutyl, tert-butyl, n-pentyl, isopentyl, neopentyl, and n-hexyl; linear or branched alkyloxys of 1 to 6 carbon atoms, such as methyloxy, ethyloxy, and propyloxy; alkenyls, such as vinyl and allyl; aryloxys, such as phenyloxy and tolyloxy; arylalkyloxys, such as benzyloxy and phenethyloxy; an aromatic hydrocarbon group or a condensed polycyclic aromatic group, such as phenyl, biphenylyl, terphenylyl, naphthyl, anthracenyl, phenanthrenyl, fluorenyl, indenyl, pyrenyl, perylenyl, fluoranthenyl, and triphenylenyl; an aromatic heterocyclic group, such as pyridyl, pyrimidinyl, triazinyl, thienyl, furyl, pyrrolyl, quinolyl, isoquinolyl, benzofuranyl, benzothienyl, indolyl, carbazolyl, benzoxazolyl, benzothiazolyl, quinoxalinyl, benzimidazolyl, pyrazolyl, dibenzofuranyl, dibenzothienyl, and carbolinyl; arylvinyls, such as styryl and naphthylvinyl; acyls, such as acetyl and benzoyl. These substituents may be further substituted with the exemplified substituents above. These substituents may bind to each other via a single bond, substituted or unsubstituted methylene, an oxygen atom, or a sulfur atom to form a ring.

Specific examples of the "aromatic hydrocarbon", the "aromatic heterocyclic ring", or the "condensed polycyclic aromatics" of the "substituted or unsubstituted aromatic hydrocarbon", the "substituted or unsubstituted aromatic heterocyclic ring", or the "substituted or unsubstituted condensed polycyclic aromatics" in the "divalent group of a substituted or unsubstituted aromatic hydrocarbon", the "divalent group of a substituted or unsubstituted aromatic heterocyclic ring", or the "divalent group of substituted or unsubstituted condensed polycyclic aromatics" represented by A₁ and A₂ in the general formula (1), the general formula (1a), and the general formula (1b) include benzene, biphenyl, terphenyl, tetrakisphenyl, styrene, naphthalene, anthracene, acenaphthalene, fluorene, phenanthrene, indane, pyrene, triphenylen, pyridine, pyrimidine, triazine, pyrrole, furan, thiophene, quinoline, isoquinoline, benzofuran, benzothiophene, indoline, carbazole, carboline, benzoxazole, benzothiazole, quinoxaline, benzimidazole, pyrazole, dibenzofuran, dibenzothiophene, naphthyridine, phenanthroline, and acridine.

The "divalent group of a substituted or unsubstituted aromatic hydrocarbon", the "divalent group of a substituted or unsubstituted aromatic heterocyclic ring", or the "divalent group of substituted or unsubstituted condensed polycyclic aromatics" represented by A₁ and A₂ in the general formula (1), the general formula (1a), and the general formula (1b) is a divalent group that results from the removal of two hydrogen atoms from the above "aromatic hydrocarbon", "aromatic heterocyclic ring", or "condensed polycyclic aromatics".

Examples of the "substituent" of the "substituted aromatic hydrocarbon", the "substituted aromatic heterocyclic ring", or the "substituted condensed polycyclic aromatics" in the "divalent group of a substituted or unsubstituted aromatic hydrocarbon", the "divalent group of a substituted or unsubstituted aromatic heterocyclic ring", or the "divalent group of substituted or unsubstituted condensed polycyclic aromatics" represented by A₁ and A₂ in the general formula (1), the general formula (1a), and the general formula (1b) include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a), and the general formula (1b), and possible embodiments may also be the same embodiments as the exemplified embodiments.

Specific examples of the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₁ to R₆ in the general formula (1), the general formula (1a), and the general formula (1b) include methyl, ethyl, n-propyl, isopropyl, n-butyl, isobutyl, tert-butyl, n-pentyl, isopentyl, neopentyl, n-hexyl, cyclopentyl, cyclohexyl, 1-adamantyl, 2-adamantyl, vinyl, allyl, isopropenyl, and 2-butenyl. These groups may bind to each other via a single bond, substituted or unsubstituted methylene, an oxygen atom, or a sulfur atom to form a ring.

Specific examples of the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₁ to R₆ in the general formula (1), the general formula (1a), and the general formula (1b) include a deuterium atom, cyano, nitro; halogen atoms, such as a fluorine atom, a chlorine atom, a bromine atom, and an iodine atom; linear or branched alkyloxys of 1 to 6 carbon atoms, such as methyloxy, ethyloxy, and propyloxy; alkenyls, such as vinyl and allyl; aryloxys, such as phenyloxy and tolyloxy; arylalkyloxys, such as benzyloxy and phenethyloxy; an aromatic hydrocarbon group or a condensed polycyclic aromatic group, such as phenyl, biphenylyl, terphenylyl, naphthyl, anthracenyl, phenanthrenyl, fluorenyl, indenyl, pyrenyl, perylenyl, fluoranthenyl, and triphenylenyl; and an aromatic heterocyclic group, such as pyridyl, pyrimidinyl, triazinyl, thienyl, furyl, pyrrolyl, quinolyl, isoquinolyl, benzofuranyl, benzothienyl, indolyl, carbazolyl, benzoxazolyl, benzothiazolyl, quinoxalinyl, benzimidazolyl, pyrazolyl, dibenzofuranyl, dibenzothienyl, and carbolinyl. These substituents may be further substituted with the exemplified substituents above. These substituents may bind to each other via a single bond, substituted or unsubstituted methylene, an oxygen atom, or a sulfur atom to form a ring.

Specific examples of the "linear or branched alkyloxy of 1 to 6 carbon atoms" or the "cycloalkyloxy of 5 to 10 carbon atoms" in the "linear or branched alkyloxy of 1 to 6 carbon atoms that may have a substituent" or the "cycloalkyloxy of 5 to 10 carbon atoms that may have a substituent" represented by R₁ to R₆ in the general formula (1), the general formula (1a) and the general formula (1b) include methyloxy, ethyloxy, n-propyloxy, isopropyloxy, n-butyloxy, tert-butyloxy, n-pentyloxy, n-hexyloxy, cyclopentyloxy, cyclohexyloxy, cycloheptyloxy, cyclooctyloxy, 1-adamantyloxy, and 2-adamantyloxy. These groups may bind to each other via a single bond, substituted or unsubstituted methylene, an oxygen atom, or a sulfur atom to form a ring.

Examples of the "substituent" in the "linear or branched alkyloxy of 1 to 6 carbon atoms that has a substituent" or the "cycloalkyloxy of 5 to 10 carbon atoms that has a substituent" represented by R₁ to R₆ in the general formula (1), the general formula (1a) and the general formula (1b) include the same substituents exemplified as the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₁ to R₆ in the general formula (1), the general formula (1a) and the general formula (1b), and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by R₁ to R₆ in the general formula (1), the general formula (1a) and the general formula (1b) include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₆ in the general formula (1), the general formula (1a) and the general formula (1b). These groups may bind to each other via a single bond, substituted or unsubstituted methylene, an oxygen atom, or a sulfur atom to form a ring.

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a) and the general formula (1b), and possible embodiments may also be the same embodiments as the exemplified embodiments.

Specific examples of the "aryloxy" in the "substituted or unsubstituted aryloxy" represented by R₁ to R₆ in the general formula (1), the general formula (1a) and the general formula (1b) include phenyloxy, biphenylyloxy, terphenylyloxy, naphthyloxy, anthracenyloxy, phenanthrenyloxy, fluorenyloxy, indenyloxy, pyrenyloxy, and perylenyloxy. These groups may bind to each other via a single bond, substituted or unsubstituted methylene, an oxygen atom, or a sulfur atom to form a ring.

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a) and the general formula (1b), and possible embodiments may also be the same embodiments as the exemplified embodiments.

Examples of the "aromatic hydrocarbon", the "aromatic heterocyclic ring", or the "condensed polycyclic aromatics" of the "substituted or unsubstituted aromatic hydrocarbon", the "substituted or unsubstituted aromatic heterocyclic ring", or the "substituted or unsubstituted condensed polycyclic aromatics" in the "divalent group of a substituted or unsubstituted aromatic hydrocarbon", the "divalent group of a substituted or unsubstituted aromatic heterocyclic ring", or the "divalent group of substituted or unsubstituted condensed polycyclic aromatics" represented by A₃ in the general formula (2), the general formula (2a), the general formula (2b), and the general formula (2c) include the same compounds exemplified as the compounds for the "aromatic hydrocarbon", the "aromatic heterocyclic ring", or the "condensed polycyclic aromatics" of the "substituted or unsubstituted aromatic hydrocarbon", the "substituted or unsubstituted aromatic heterocyclic ring", or the "substituted or unsubstituted condensed polycyclic aromatics" in the "divalent group of a substituted or unsubstituted aromatic hydrocarbon", the "divalent group of a substituted or unsubstituted aromatic heterocyclic ring", or the "divalent group of substituted or unsubstituted condensed polycyclic aromatics" represented by A₁ and A₂ in the general formula (1), the general formula (1a) and the general formula (1b).

The "divalent group of a substituted or unsubstituted aromatic hydrocarbon", the "divalent group of a substituted or unsubstituted aromatic heterocyclic ring", or the "divalent group of substituted or unsubstituted condensed polycyclic aromatics" represented by A₃ in the general formula (2), the general formula (2a), the general formula (2b), and the general formula (2c) is a divalent group that results from the removal of two hydrogen atoms from the above "aromatic hydrocarbon", "aromatic heterocyclic ring", or "condensed polycyclic aromatics".

Examples of the "substituent" of the "substituted aromatic hydrocarbon", the "substituted aromatic heterocyclic ring", or the "substituted condensed polycyclic aromatics" in the "divalent group of a substituted or unsubstituted aromatic hydrocarbon", the "divalent group of a substituted or unsubstituted aromatic heterocyclic ring", or the "divalent group of substituted or unsubstituted condensed polycyclic aromatics" represented by A₃ in the general formula (2), the general formula (2a), the general formula (2b) and the general formula (2c) include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a) and the general formula (1b), and possible embodiments may also be the same embodiments as the exemplified embodiments.

Specific examples of the "aromatic heterocyclic group" in the "substituted or unsubstituted aromatic heterocyclic group" represented by B in the general formula (2) include triazinyl, pyridyl, pyrimidinyl, furyl, pyrrolyl, thienyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, naphthyridinyl, phenanthrolinyl, acridinyl, and carbolinyl.

Specific examples of the "substituent" in the "substituted aromatic heterocyclic group" represented by B in the general formula (2) include a deuterium atom, cyano, nitro; halogen atoms such as a fluorine atom, a chlorine atom, a bromine atom, and an iodine atom; linear or branched alkyls of 1 to 6 carbon atoms such as methyl, ethyl, n-propyl, isopropyl, n-butyl, isobutyl, tert-butyl, n-pentyl, isopentyl, neopentyl, and n-hexyl; cycloalkyls of 5 to 10 carbon atoms such as cyclopentyl, cyclohexyl, 1-adamantyl, and 2-adamantyl; linear or branched alkyloxys of 1 to 6 carbon atoms such as methyloxy, ethyloxy, and propyloxy; cycloalkyloxys of 5 to 10 carbon atoms such as cyclopentyloxy, cyclohexyloxy, 1-adamantyloxy, and 2-adamantyloxy; alkenyls such as vinyl and allyl; aryloxys such as phenyloxy and tolyloxy; arylalkyloxys such as benzyloxy and phenethyloxy; aromatic hydrocarbon groups or condensed polycyclic aromatic groups such as phenyl, biphenylyl, terphenylyl, naphthyl, anthracenyl, phenanthrenyl, fluorenyl, indenyl, pyrenyl, perylenyl, fluoranthenyl, and triphenylenyl; aromatic heterocyclic groups such as pyridyl, pyrimidinyl, triazinyl, thienyl, furyl, pyrrolyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, and carbolinyl; aryloxys such as phenyloxy, biphenylyloxy, naphthyloxy, anthracenylox, and phenanthrenyloxy; arylvinyls such as styryl and naphthylvinyl; and acyls such as acetyl and benzoyl. These substituents may be further substituted with the exemplified substituents above. These substituents may bind to each other via a single bond, substituted or unsubstituted methylene, an oxygen atom, or a sulfur atom to form a ring.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by C in the general formula (2) include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₆ in the general formula (1), the general formula (1a) and the general formula (1b). When a plurality of these groups bind to the same anthracene ring (when q is 2), these groups may be the same or different.

Examples of the "substituent" in the "substituted aromatic hydrocarbon group", the "substituted aromatic heterocyclic group", or the "substituted condensed polycyclic aromatic group" represented by C in the general formula (2) include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a) and the general formula (1b), and possible embodiments may also be the same embodiments as the exemplified embodiments.

Specific examples of the "linear or branched alkyl of 1 to 6 carbon atoms" represented by D in the general formula (2) include methyl, ethyl, n-propyl, isopropyl, n-butyl, isobutyl, tert-butyl, n-pentyl, isopentyl, neopentyl, and n-hexyl. The plurality of D may be the same or different, and these groups may bind to each other via a single bond, substituted or unsubstituted methylene, an oxygen atom, or a sulfur atom to form a ring.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by D in the general formula (2) include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₆ in the general formula (1), the general formula (1a) and the general formula (1b). The plurality of D may be the same or different, and these groups may bind to each other via a single bond, substituted or unsubstituted methylene, an oxygen atom, or a sulfur atom to form a ring.

Examples of the "substituent" in the "substituted aromatic hydrocarbon group", the "substituted aromatic heterocyclic group", or the "substituted condensed polycyclic aromatic group" represented by D in the general formula (2) include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a) and the general formula (1b), and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₇, Ar₈, and Ar₉ in the general formula (2a) include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₆ in the general formula (1), the general formula (1a) and the general formula (1b).

Examples of the "substituent" in the "substituted aromatic hydrocarbon group", the "substituted aromatic heterocyclic group", or the "substituted condensed polycyclic aromatic group" represented by Ar₇, Ar₈, and Ar₉ in the general formula (2a) include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a) and the general formula (1b), and possible embodiments may also be the same embodiments as the exemplified embodiments.

Specific examples of the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₇ to R₁₃ in the general formula (2a) include methyl, ethyl, n-propyl, isopropyl, n-butyl, isobutyl, tert-butyl, n-pentyl, isopentyl, neopentyl, n-hexyl, cyclopentyl, cyclohexyl, 1-adamantyl, 2-adamantyl, vinyl, allyl, isopropenyl, and 2-butenyl, and these groups may bind to each other via a single bond, substituted or unsubstituted methylene, an oxygen atom, or a sulfur atom to form a ring.

Specific examples of the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₇ to R₁₃ in the general formula (2a) include a deuterium atom, cyano, nitro, halogen atoms such as a fluorine atom, a chlorine atom, a bromine atom, and an iodine atom; linear or branched alkyloxys of 1 to 6 carbon atoms such as methyloxy, ethyloxy, and propyloxy; alkenyls such as vinyl and allyl; aryloxys such as phenyloxy and tolyloxy; arylalkyloxys such as benzyloxy and phenethyloxy; aromatic hydrocarbon groups or condensed polycyclic aromatic groups such as phenyl, biphenylyl, terphenylyl, naphthyl, anthracenyl, phenanthrenyl, fluorenyl, indenyl, pyrenyl, perylenyl, fluoranthenyl, and triphenylenyl; aromatic heterocyclic groups such as pyridyl, pyrimidinyl, triazinyl, thienyl, furyl, pyrrolyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, and carbolinyl. These substituents may be further substituted with the exemplified substituents above. These substituents may bind to each other via a single bond, substituted or unsubstituted methylene, an oxygen atom, or a sulfur atom to form a ring.

Specific examples of the "linear or branched alkyloxy of 1 to 6 carbon atoms" or the "cycloalkyloxy of 5 to 10 carbon atoms" in the "linear or branched alkyloxy of 1 to 6 carbon atoms that may have a substituent" or the "cycloalkyloxy of 5 to 10 carbon atoms that may have a substituent" represented by R₇ to R₁₃ in the general formula (2a) include methyloxy, ethyloxy, n-propyloxy, isopropyloxy, n-butyloxy, tert-butyloxy, n-pentyloxy, n-hexyloxy, cyclopentyloxy, cyclohexyloxy, cycloheptyloxy, cyclooctyloxy, 1-adamantyloxy, and 2-adamantyloxy. These groups may bind to each other via a single bond, substituted or unsubstituted methylene, an oxygen atom, or a sulfur atom to form a ring.

Examples of the "substituent" in the "linear or branched alkyloxy of 1 to 6 carbon atoms that has a substituent" or the "cycloalkyloxy of 5 to 10 carbon atoms that has a substituent" represented by R₇ to R₁₃ in the general formula (2a) include the same substituents exemplified as the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₇ to R₁₃ in the general formula (2a), and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by R₇ to R₁₃ in the general formula (2a) include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₆ in the general formula (1), the general formula (1a), and the general formula (1b). These groups may bind to each other via a single bond, substituted or unsubstituted methylene, an oxygen atom, or a sulfur atom to form a ring.

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a), and the general formula (1b), and possible embodiments may also be the same embodiments as the exemplified embodiments.

Specific examples of the "aryloxy" in the "substituted or unsubstituted aryloxy" represented by R₇ to R₁₃ in the general formula (2a) include phenyloxy, biphenylyloxy, terphenylyloxy, naphthyloxy, anthracenyloxy, phenanthrenyloxy, fluorenyloxy, indenyloxy, pyrenyloxy, and perylenyloxy. These groups may bind to each other via a single bond, substituted or unsubstituted methylene, an oxygen atom, or a sulfur atom to form a ring.

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a) and the general formula (1b), and possible embodiments may also be the same embodiments as the exemplified embodiments.

In the general formula (2a), X₁, X₂, X₃, and X₄ represent a carbon atom or a nitrogen atom, and only one of X₁, X₂, X₃, and X₄ is a nitrogen atom. In this case, the nitrogen atom does not have the hydrogen atom or substituent for R₇ to R₁₀. That is, R₇ does not exist when X₁ is a nitrogen atom, R₈ does not exist when X₂ is a nitrogen atom, R₉ does not exist when X₃ is a nitrogen atom, and R₁₀ does not exist when X₄ is a nitrogen atom.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁₀, Ar₁₁, and Ar₁₂ in the general formula (2b) include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₆ in the general formula (1), the general formula (1a) and the general formula (1b).

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a) and the general formula (1b), and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁₃, Ar₁₄, and Ar₁₅ in the general formula (2c) include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₆ in the general formula (1), the general formula (1a) and the general formula (1b).

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a) and the general formula (1b), and possible embodiments may also be the same embodiments as the exemplified embodiments.

Examples of the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₁₄ in the general formula (2c) include the same groups exemplified as the groups for the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₇ to R₁₃ in the general formula (2a).

These groups may have a substituent, and examples of the substituent include the same substituents exemplified as the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₇ to R₁₃ in the general formula (2a).

Examples of the "linear or branched alkyloxy of 1 to 6 carbon atoms", or the "cycloalkyloxy of 5 to 10 carbon atoms" in the "linear or branched alkyloxy of 1 to 6 carbon atoms that may have a substituent", or the "cycloalkyloxy of 5 to 10 carbon atoms that may have a substituent" represented by R₁₄ in the general formula (2c) include the same groups exemplified as the groups for the "linear or branched alkyloxy of 1 to 6 carbon atoms", or the "cycloalkyloxy of 5 to 10 carbon atoms" in the "linear or branched alkyloxy of 1 to 6 carbon atoms that may have a substituent", or the "cycloalkyloxy of 5 to 10 carbon atoms that may have a substituent" represented by R₇ to R₁₃ in the general formula (2a).

These groups may have a substituent, and examples of the substituent include the same substituents exemplified as the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₇ to R₁₃ in the general formula (2a).

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by R₁₄ in the general formula (2c) include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₆ in the general formula (1), the general formula (1a), and the general formula (1b).

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a), and the general formula (1b), and possible embodiments may also be the same embodiments as the exemplified embodiments.

Examples of the "aryloxy" in the "substituted or unsubstituted aryloxy" represented by R₁₄ in the general formula (2c) include the same groups exemplified as the groups for the "aryloxy" in the "substituted or unsubstituted aryloxy" represented by R₇ to R₁₃ in the general formula (2a).

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₆ in the general formula (1), the general formula (1a), and the general formula (1b), and possible embodiments may also be the same embodiments as the exemplified embodiments.

Ar₁ to Ar₆ in the general formula (1) are preferably an aromatic hydrocarbon group, a condensed polycyclic aromatic group, benzofuranyl, benzothienyl, carbazolyl, dibenzofuranyl, or dibenzothienyl, and may have a substituent, but are preferably unsubstituted.

Specifically, phenyl, biphenyl, naphthyl, anthracenyl, phenanthrenyl, fluorenyl, benzofuranyl, benzothienyl, carbazolyl, dibenzofuranyl or dibenzothienyl are preferred, and phenyl, biphenyl or naphthyl are more preferred.

Ar₁ and Ar₂ in the general formula (1) are preferably divalent groups that result from the removal of two hydrogen atoms from "aromatic hydrocarbon" or "condensed polycyclic aromatics". Further, divalent groups that result from the removal of two hydrogen atoms from benzofuran, benzothiophene, carbazole, dibenzofuran or dibenzothiophene are preferred, and divalent groups that result from the removal of two hydrogen atoms from "aromatic hydrocarbon" or "condensed polycyclic aromatics" are more preferred.

Specifically, divalent groups that result from the removal of two hydrogen atoms from benzene, biphenyl, naphthalene, anthracene, fluorene, phenanthrene, benzofuran, benzothiophene, carbazole, dibenzofuran or dibenzothiophene are preferred, and divalent groups that result from the removal of two hydrogen atoms from benzene, biphenyl or naphthalene are more preferred.

R₁ to R₆ in the general formula (1) are preferably a hydrogen atom, a deuterium atom, an aromatic hydrocarbon group, a condensed polycyclic aromatic group, benzofuranyl, benzothienyl, carbazolyl, dibenzofuranyl, or dibenzothienyl. The aromatic hydrocarbon group, condensed polycyclic aromatic group, benzofuranyl, benzothienyl, carbazolyl, dibenzofuranyl, or dibenzothienyl may have a substituent, but is preferably unsubstituted.

Specifically, a hydrogen atom, a deuterium atom, phenyl, biphenyl, naphthyl, anthracenyl, phenanthrenyl, fluorenyl, benzofuranyl, benzothienyl, carbazolyl, dibenzofuranyl or dibenzothienyl are preferred, and a hydrogen atom, a deuterium atom, phenyl and naphthyl are more preferred.

Among the arylamine compounds of the general formula (1), the arylamine compounds of the general formula (1a) or the general formula (1b) are also preferably used.

The "aromatic heterocyclic group" in the "substituted or unsubstituted aromatic heterocyclic group" represented by B in the general formula (2) is preferably a nitrogen-containing aromatic heterocyclic group such as pyridyl, pyrimidinyl, pyrrolyl, quinolyl, isoquinolyl, indolyl, carbazolyl, benzoxazolyl, benzothiazolyl, quinoxalinyl, benzoimidazolyl, pyrazolyl, or carbolinyl, far preferably, pyridyl, pyrimidinyl, quinolyl, isoquinolyl, indolyl, pyrazolyl, benzoimidazolyl or carbolinyl.

With respect to p and q in the general formula (2), p represents 7 or 8, and q represents 1 or 2 while maintaining a relationship that a sum of p and q (p + q) is 9.

Among the compounds of the general formula (2) having an anthracene ring structure, the compounds of the general formula (2a), the general formula (2b), or the general formula (2c) having an anthracene ring structure are far preferably used.

A₃ in the general formula (2), the general formula (2a), the general formula (2b), or the general formula (2c) is preferably the "divalent group of a substituted or unsubstituted aromatic hydrocarbon" or the "divalent group of substituted or unsubstituted condensed polycyclic aromatics", far preferably, a divalent group that results from the removal of two hydrogen atoms from benzene, biphenyl, naphthalene, or phenanthrene.

The arylamine compound of the general formula (1) with four triarylamine structures, for preferable use in the organic EL device of the present invention, is a novel compound, and has excellent electron blocking ability and stability in a thin-film state, as compared to the conventional hole transporting materials.

The arylamine compound of the general formula (1) having four triarylamine structures, for preferable use in the organic EL device of the present invention, can be used as a constitutional material of the hole injection layer and/or the hole transporting layer of the organic EL device. By using the material having higher hole injectability, larger mobility, higher electron blocking ability, and higher stability to electrons, as compared to the conventional materials, functions can be obtained that excitons generated in the light emitting layer can be confined, and further the probability of hole-electron recombination can be improved, so as to provide a high luminous efficiency, and the driving voltage is decreased, so as to improve the durability of the organic EL device.

The arylamine compound of the general formula (1) having four triarylamine structures, for preferable use in the organic EL device of the present invention, can also be used as a constitutional material of the electron blocking layer of the organic EL device. By using the material having excellent electron blocking ability, and also having excellent hole transportability and higher stability in a thin-film state, as compared to the conventional materials, functions can be obtained that the driving voltage is decreased while achieving high luminous efficiency, and the current durability is improved, so as to improve the maximum emission luminance of the organic EL device.

The arylamine compound of the general formula (1) having four triarylamine structures, for preferable use in the organic EL device of the present invention, can also be used as a constitutional material of the light emitting layer of the organic EL device. By using the material of the present invention as a host material of the light emitting layer having excellent hole transportability and a wider bandgap, as compared to the conventional materials, and using the material as the light emitting layer after carrying thereon a fluorescent-emitting material, a phosphorescent-emitting material, or a delayed fluorescent-emitting material, which is referred to as a dopant, functions can be obtained that the driving voltage is decreased, so as to achieve an organic EL device having improved luminous efficiency.

The organic EL device of the present invention uses the triarylamine compound with four triarylamine structures having larger hole mobility, excellent electron blocking ability, and stability in a thin-film state, as compared to the conventional hole transporting materials, and thus can achieve high efficiency and high durability.

The compounds of the general formula (2) having an anthracene ring structure, for preferable use in the organic EL device of the present invention, can be used as a constitutive material of an electron transport layer of an organic EL device.

The compounds of the general formula (2) having an anthracene ring structure excel in electron injection and transport abilities and further excel in stability as a thin film and durability. The compounds are therefore preferred compounds as material of an electron transport layer.

The organic EL device of the present invention combines materials for an organic EL device exceling in hole and electron injection/transport performances, stability as a thin film and durability, taking carrier balance into consideration. Therefore, compared with the conventional organic EL devices, hole transport efficiency to the light emitting layer from the hole transport layer is improved and electron transport efficiency to the light emitting layer from the electron transport layer is also improved. As a result, luminous efficiency is improved and driving voltage is decreased, and durability of the organic EL device can thereby be improved. Thus, an organic EL device having high efficiency, low driving voltage, and a long lifetime can be attained in the present invention.

### Advantageous Effects of Invention

The organic EL device of the present invention can achieve an organic EL device having high efficiency, low driving voltage and a long lifetime as a result of attaining efficient hole injection/transport into a light emitting layer by selecting specific arylamine compounds which excel in hole and electron injection/transport performances, stability as a thin film and durability and can effectively exhibit hole injection/transport roles. An organic EL device having high efficiency, low driving voltage, and a long lifetime can be achieved by selecting specific arylamine compounds, and combining those compounds and a specific electron transport material so as to achieve good carrier balance. The organic EL device of the present invention can improve luminous efficiency, driving voltage, and durability of the conventional organic EL devices.

### Brief Description of Drawings

FIG. 1 is a ¹H-NMR chart of the compound (Compound 2) of Example 1 of the present invention.
FIG. 2 is a ¹H-NMR chart of the compound (Compound 33) of Example 2 of the present invention.
FIG. 3 is a ¹H-NMR chart of the compound (Compound 56) of Example 3 of the present invention.
Fig. 4 is a diagram illustrating the configuration of the organic EL devices of Examples 6 to 8 and Comparative Example 1.

The following presents specific examples of preferred compounds among the arylamine compounds of the general formula (1) preferably used in the organic EL device of the present invention. The present invention, however, is not restricted to these compounds.

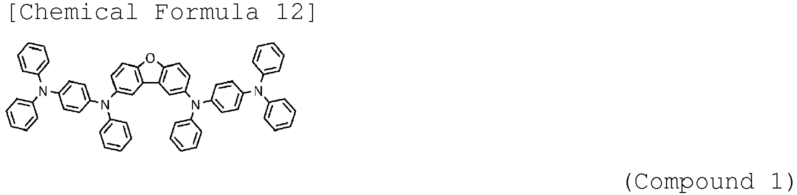

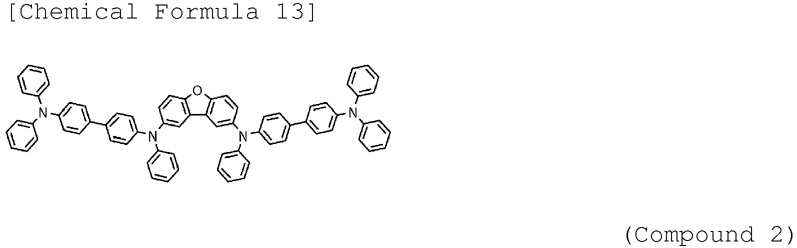

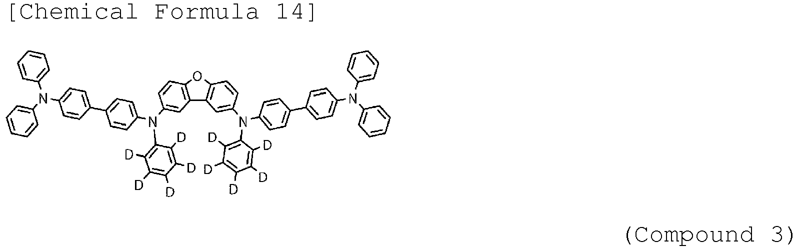

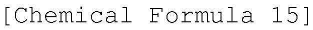

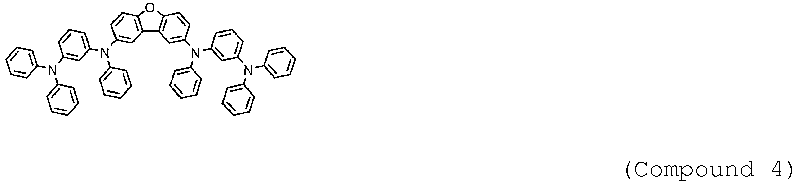

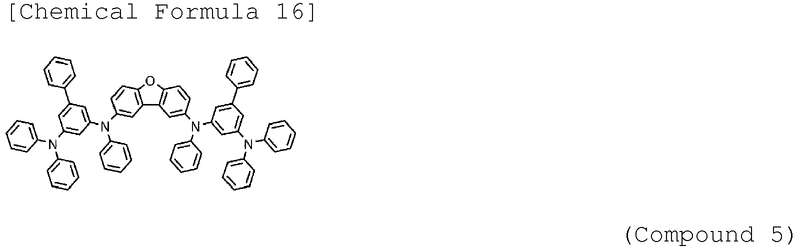

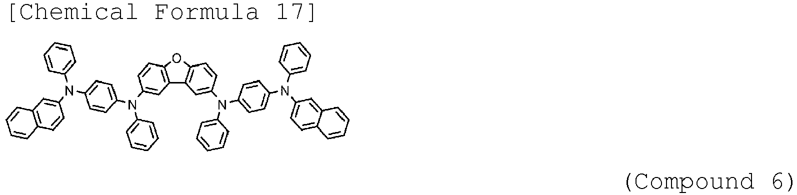

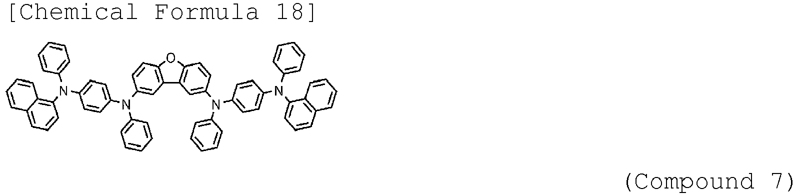

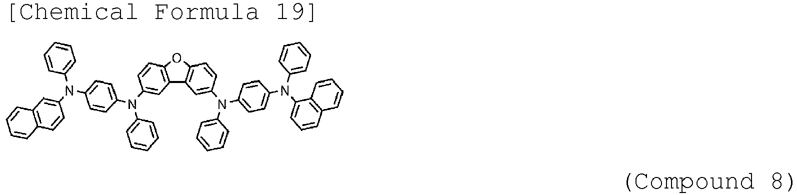

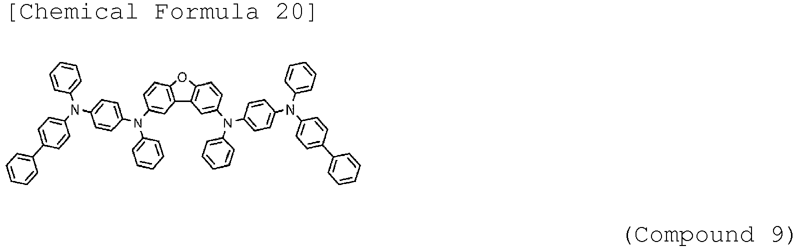

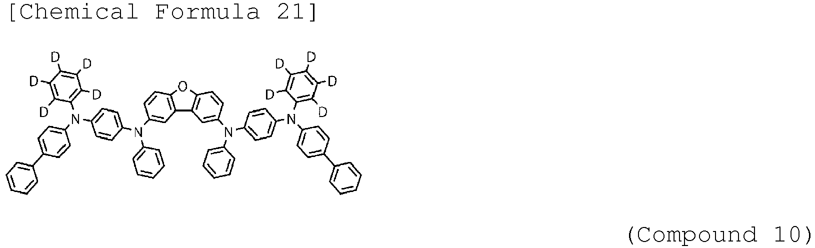

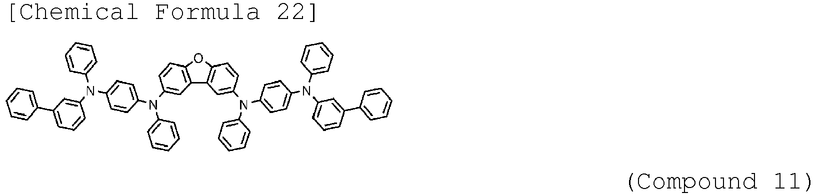

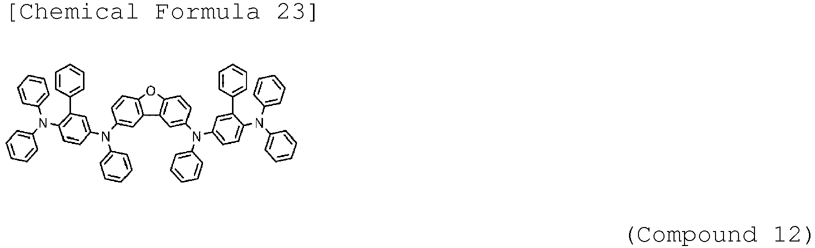

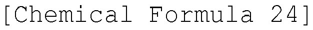

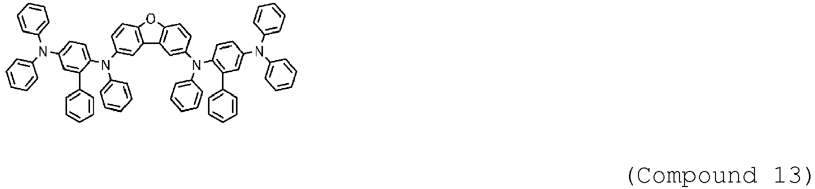

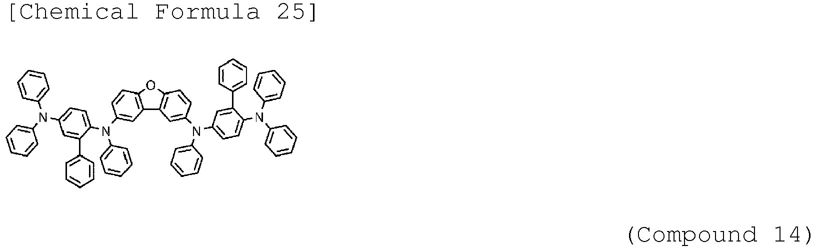

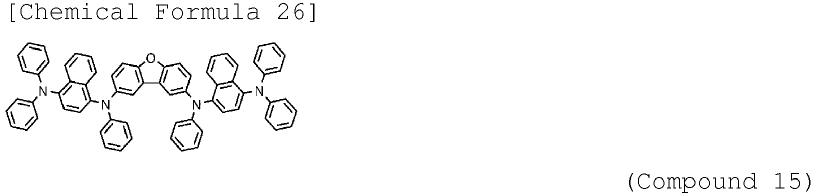

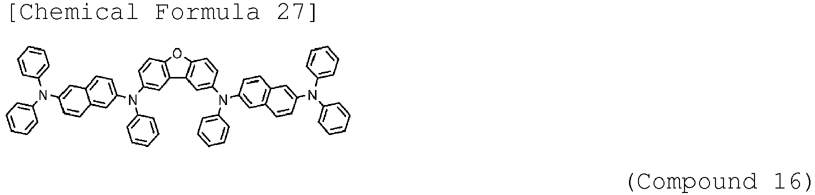

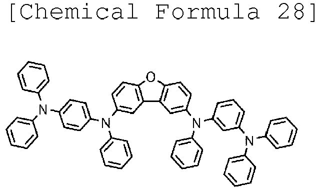

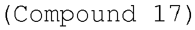

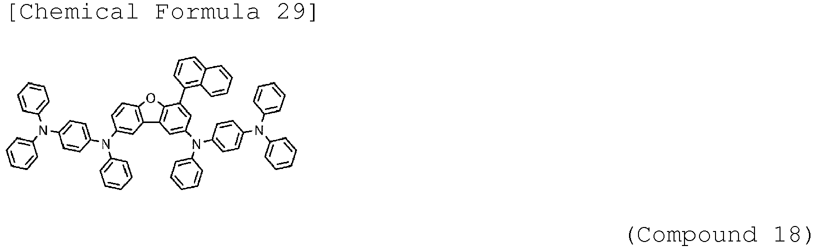

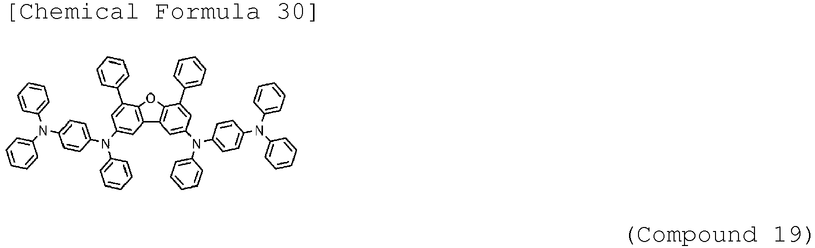

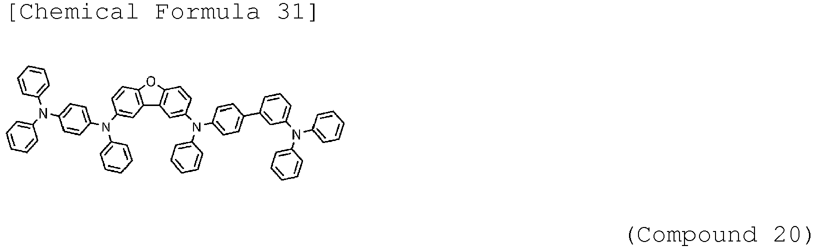

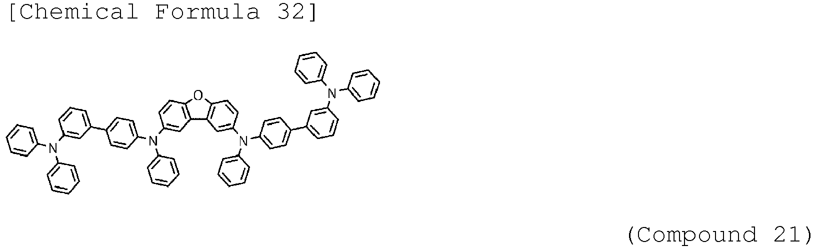

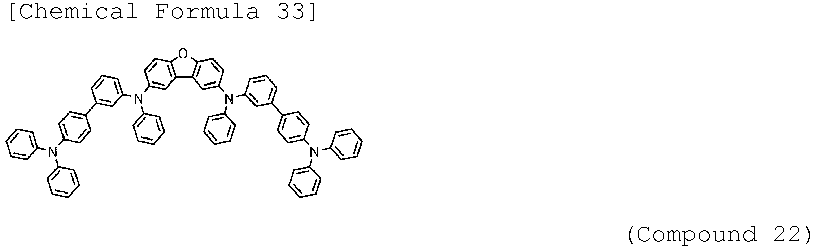

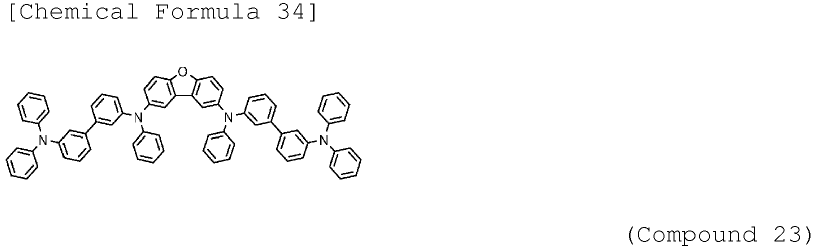

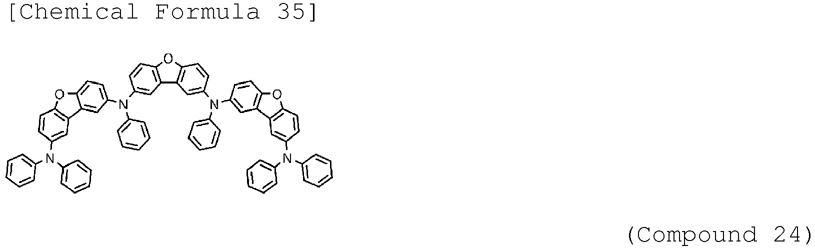

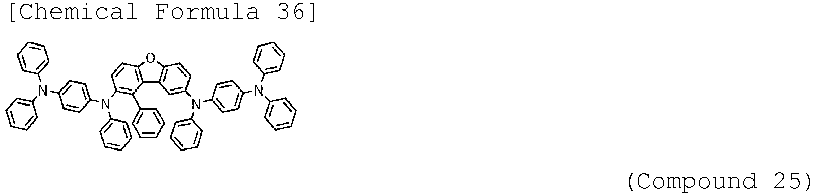

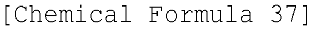

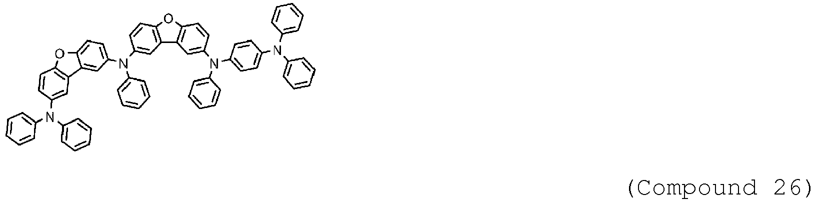

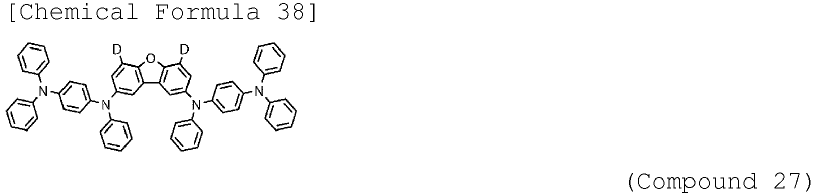

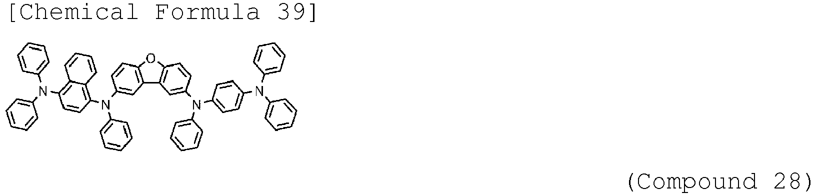

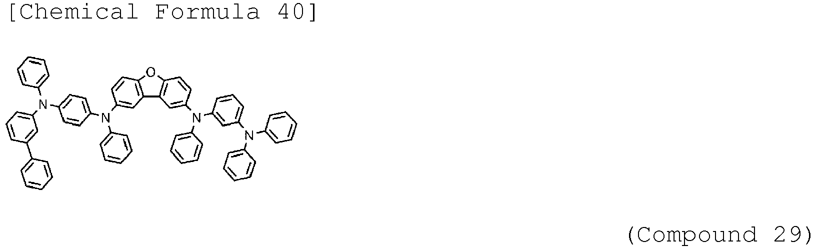

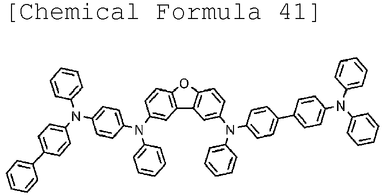

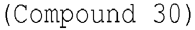

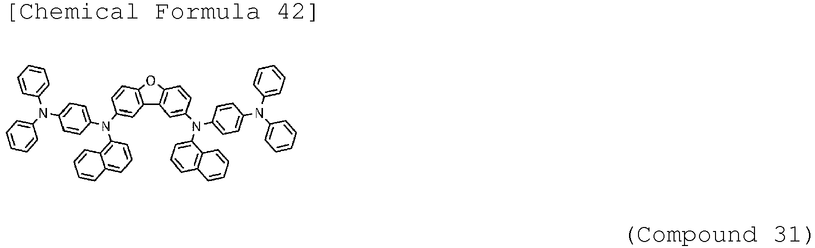

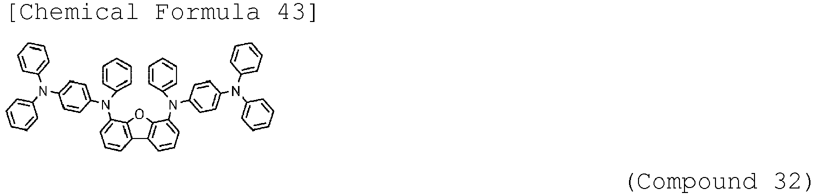

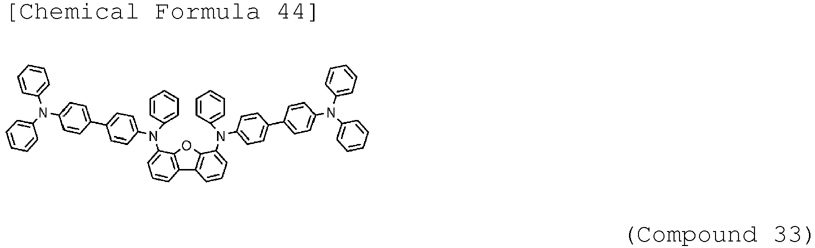

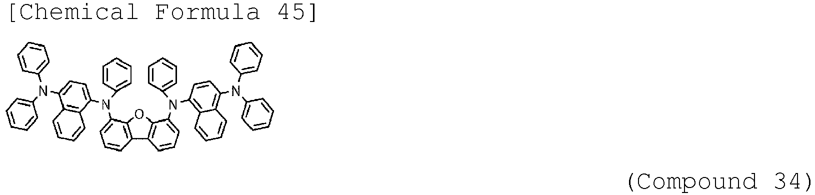

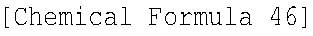

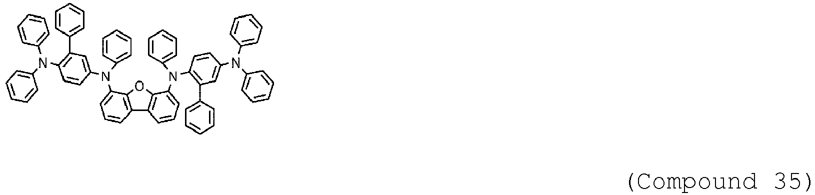

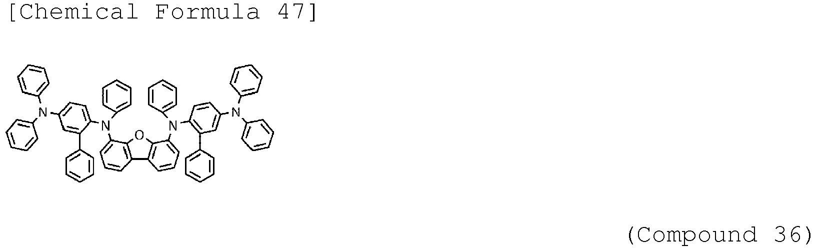

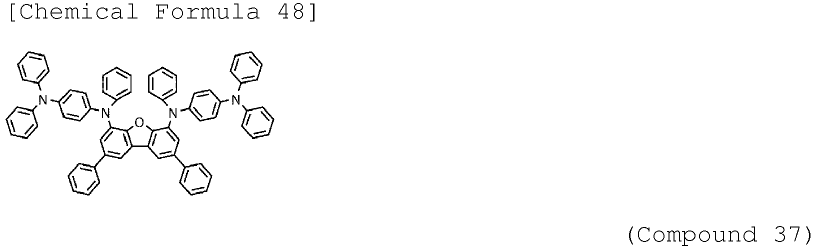

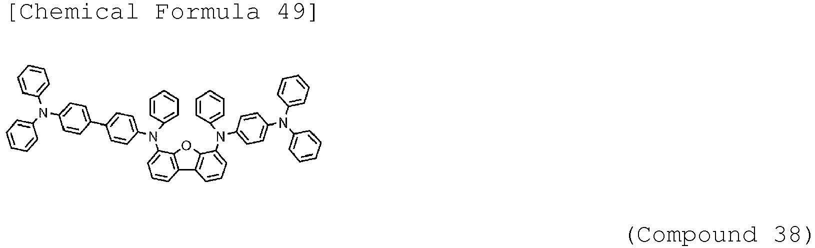

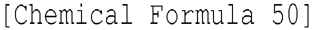

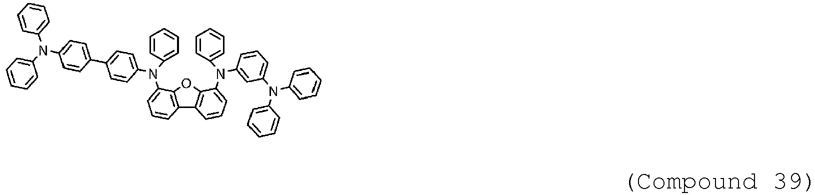

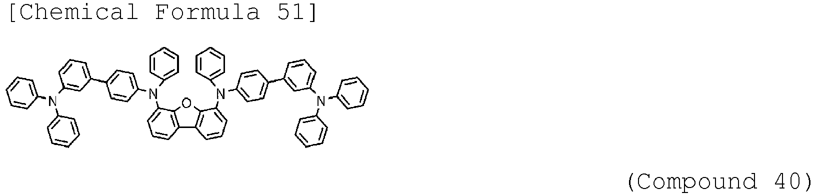

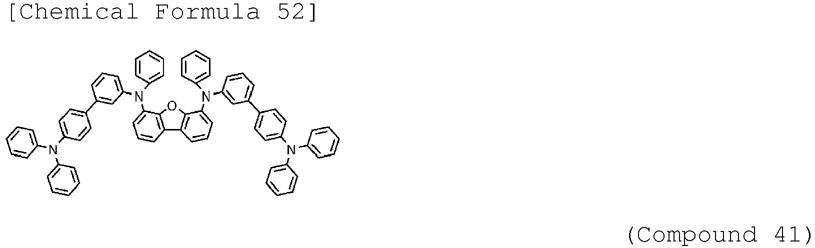

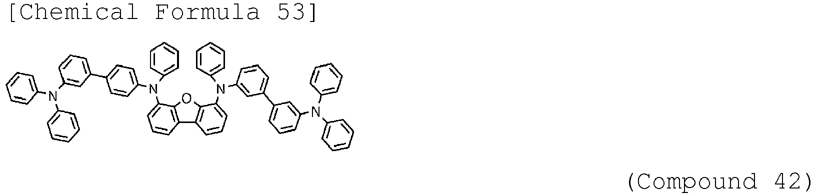

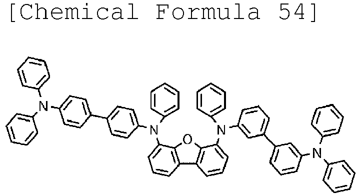

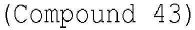

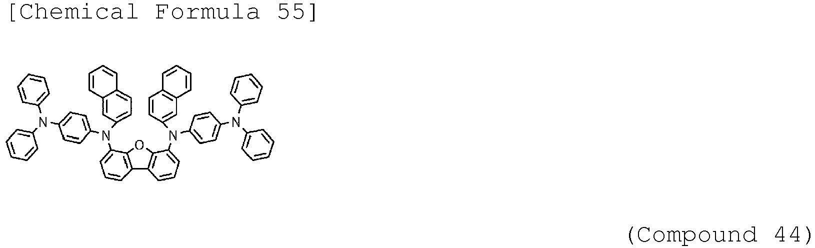

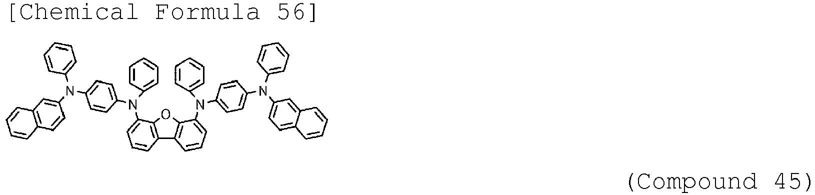

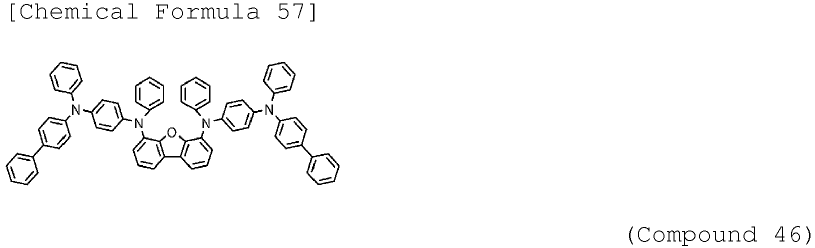

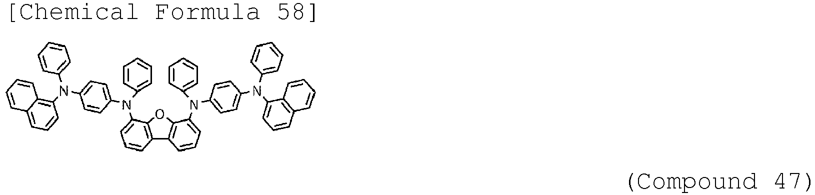

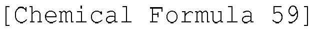

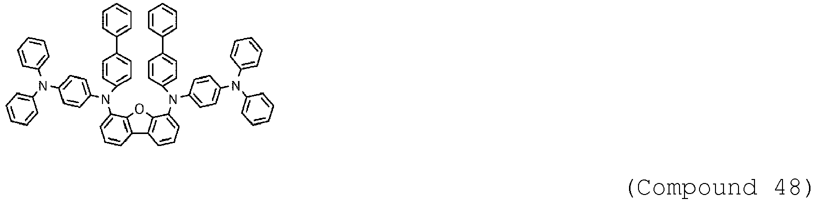

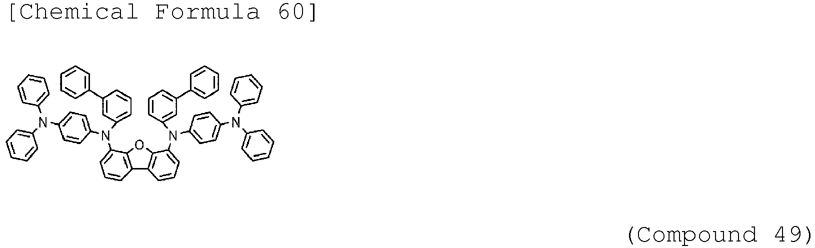

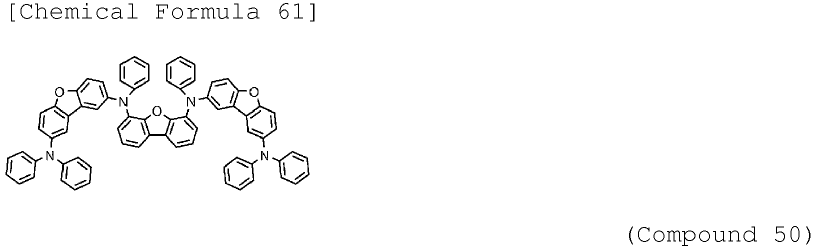

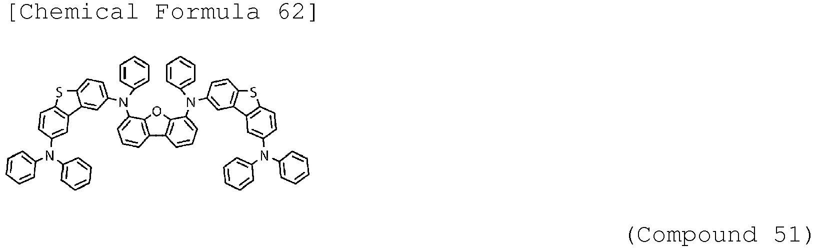

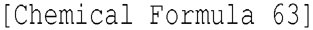

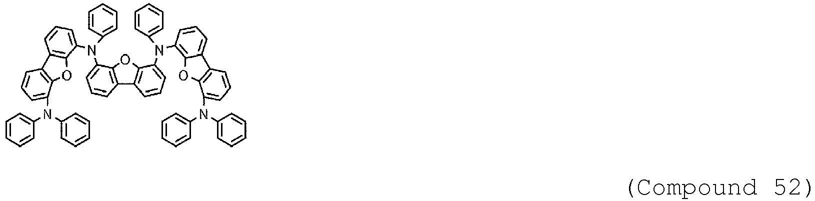

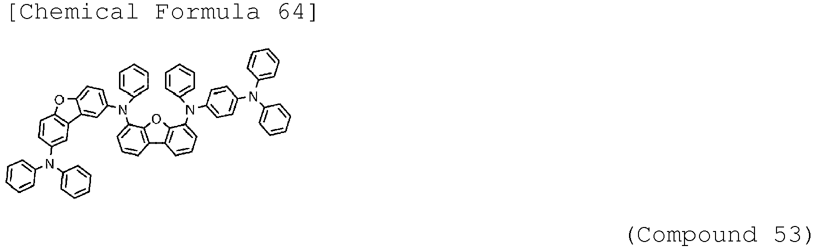

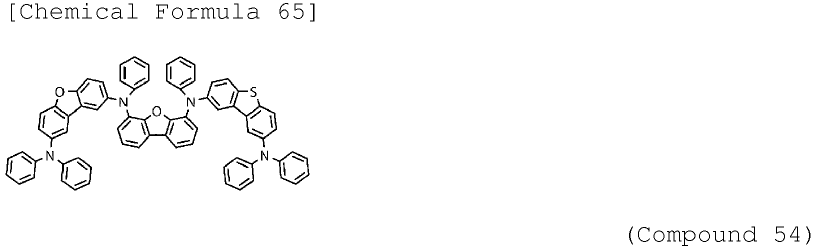

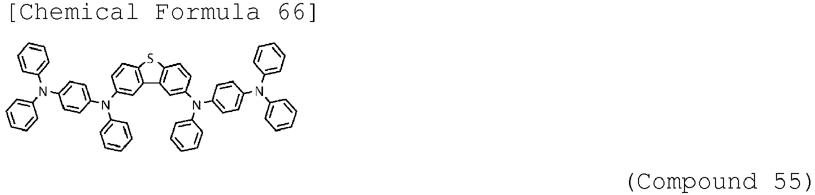

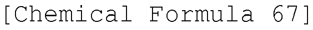

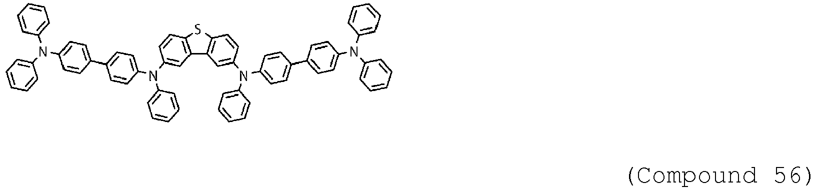

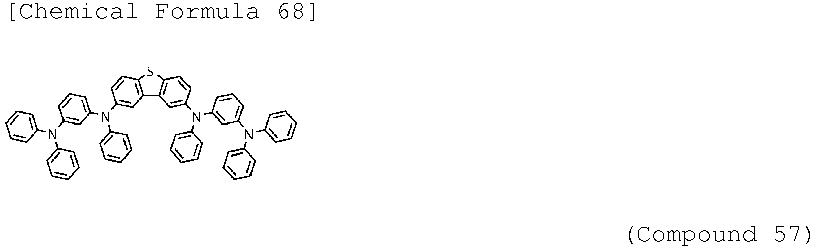

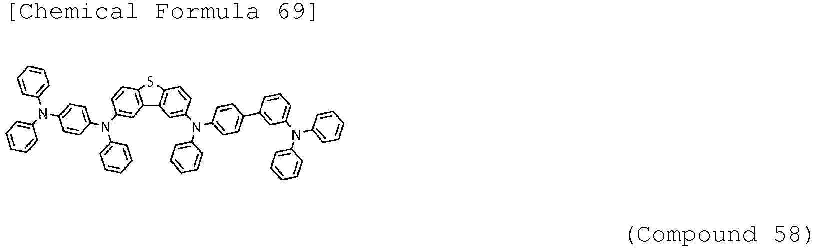

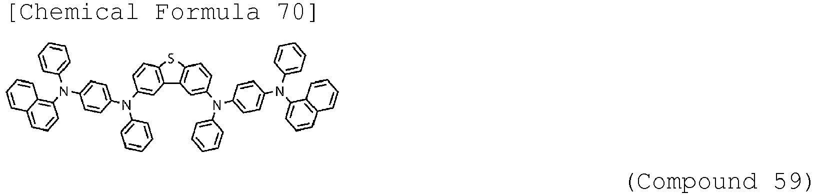

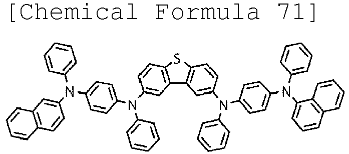

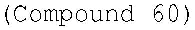

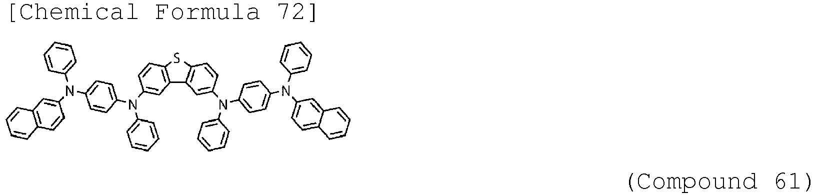

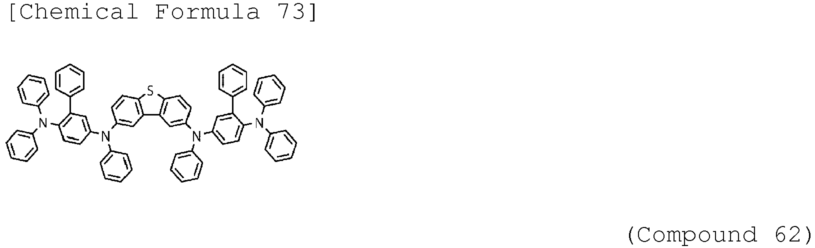

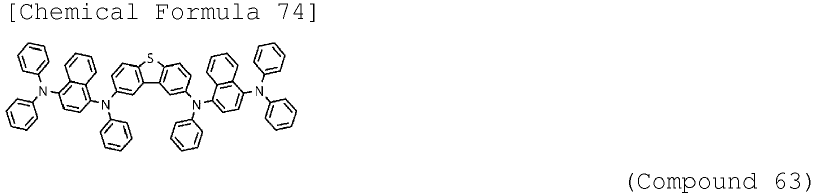

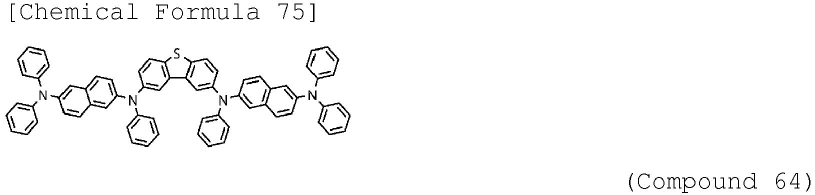

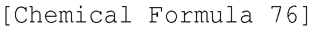

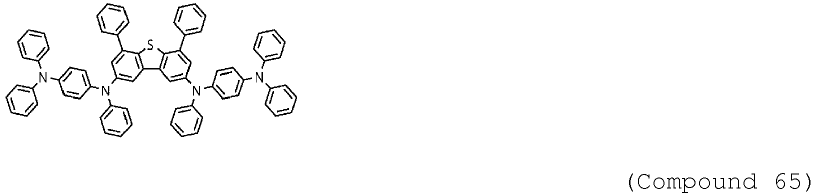

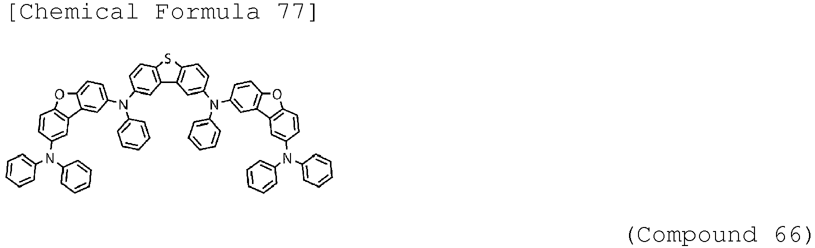

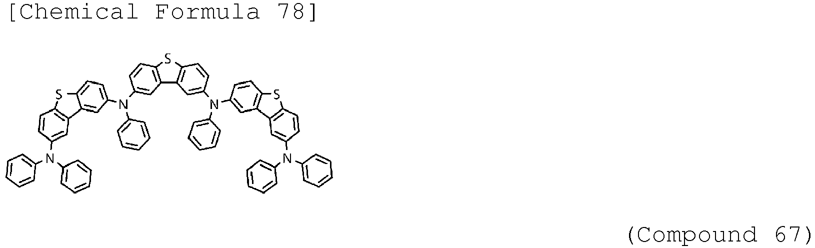

The following presents specific examples of preferred compounds among the compounds of the general formula (2a) preferably used in the organic EL device of the present invention and having an anthracene ring structure. The present invention, however, is not restricted to these compounds.

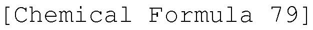

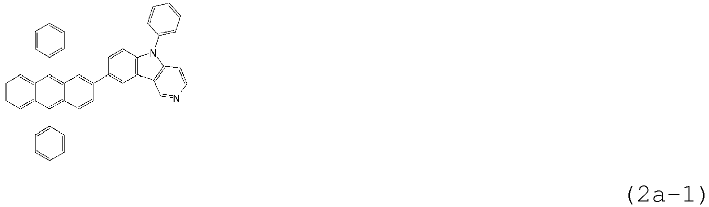

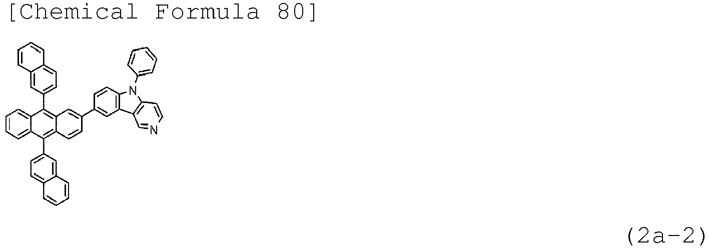

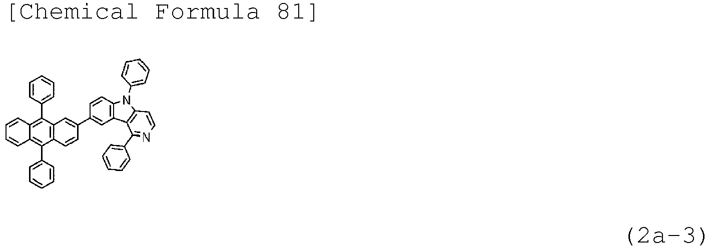

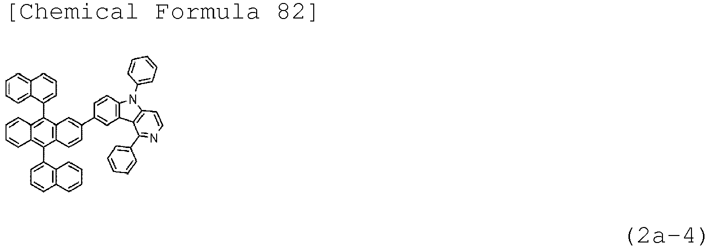

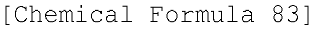

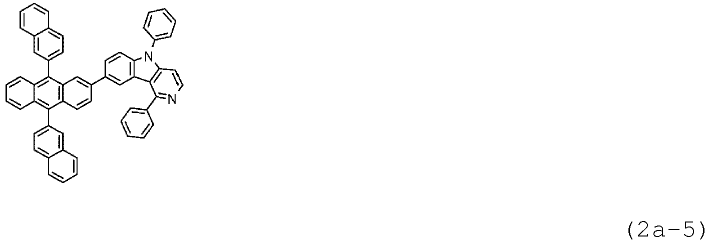

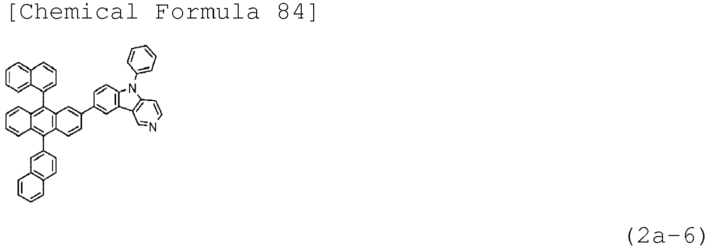

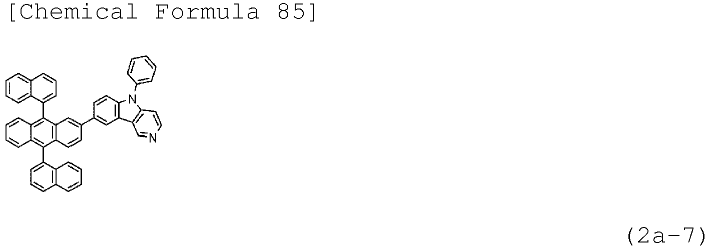

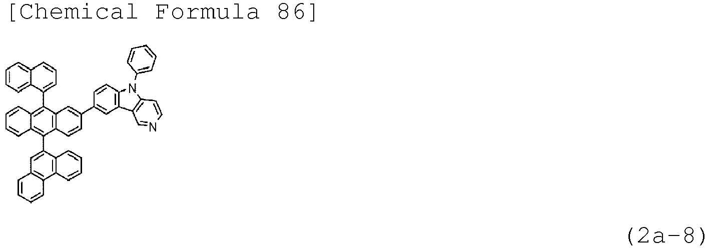

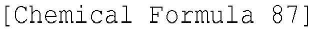

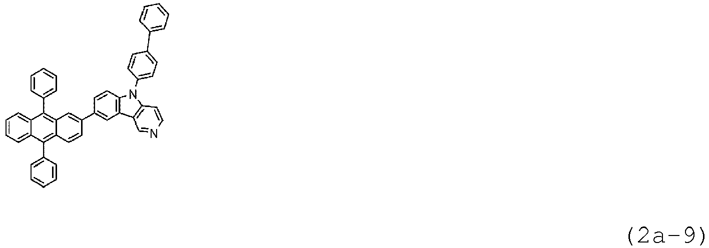

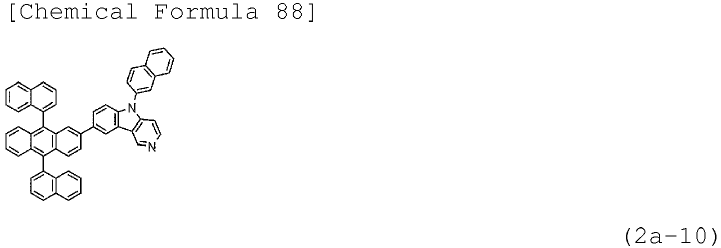

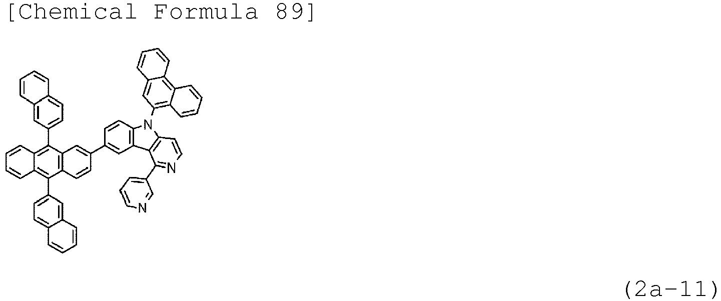

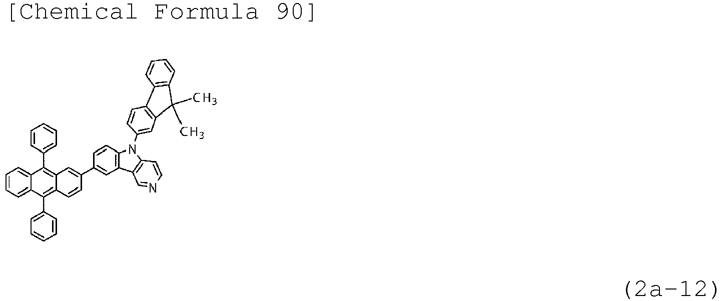

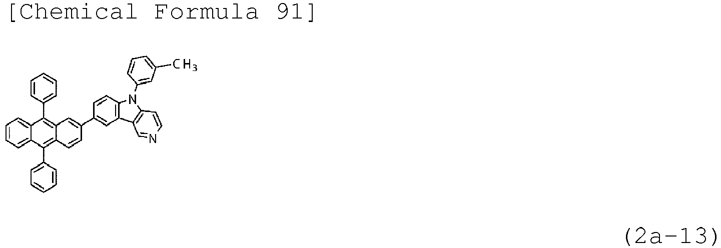

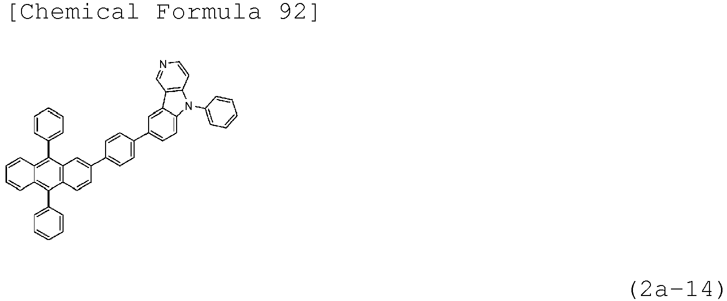

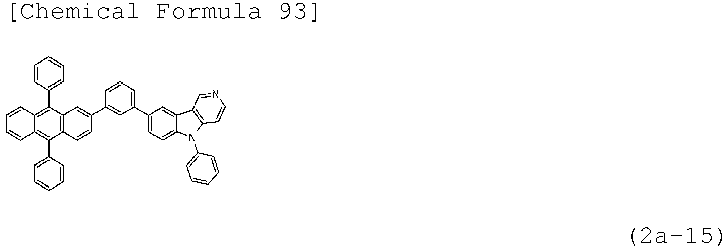

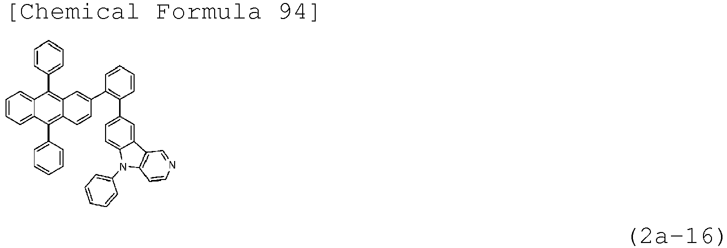

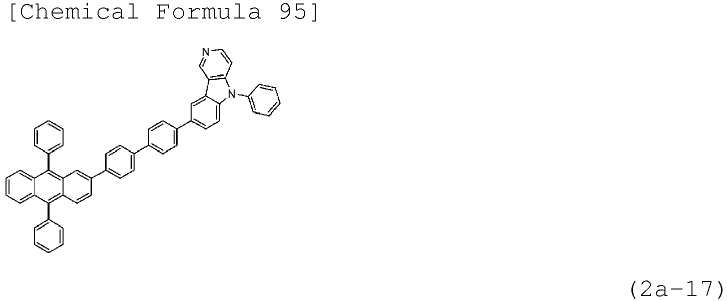

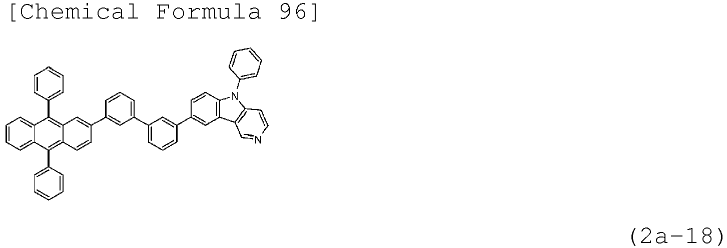

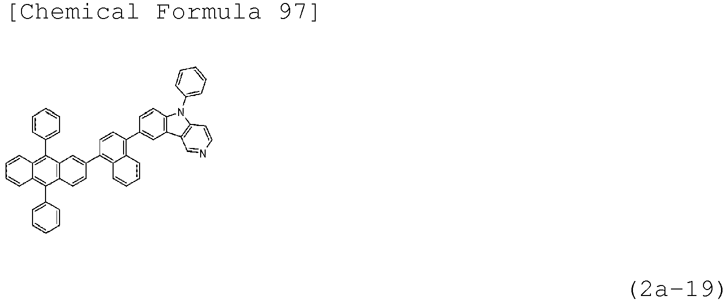

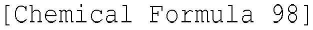

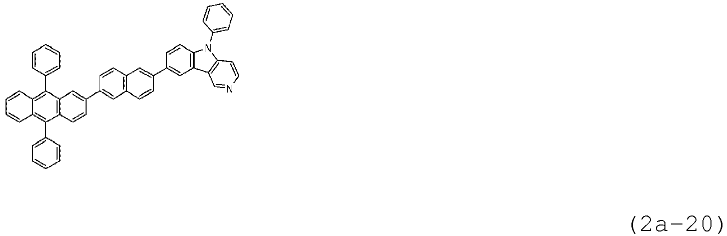

The following presents specific examples of preferred compounds among the compounds of the general formula (2b) preferably used in the organic EL device of the present invention and having an anthracene ring structure. The present invention, however, is not restricted to these compounds.

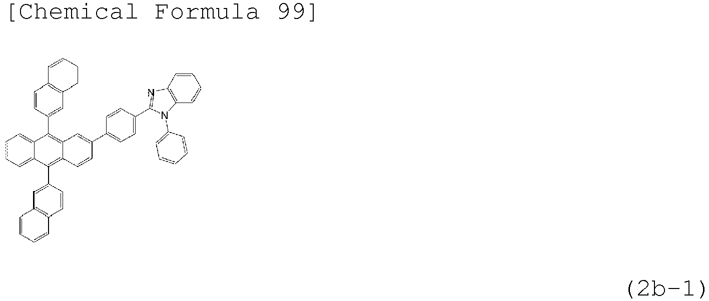

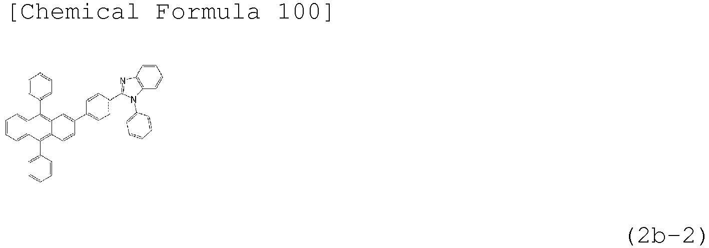

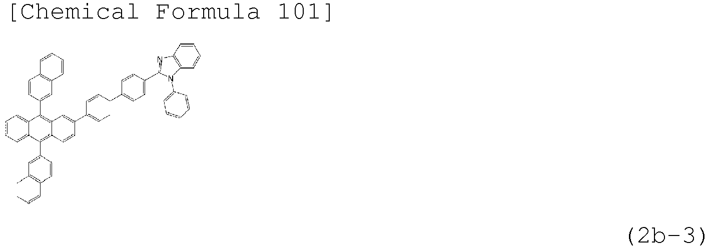

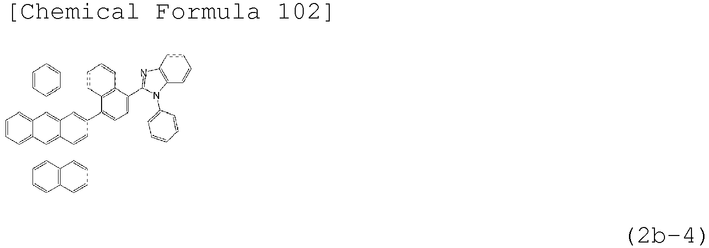

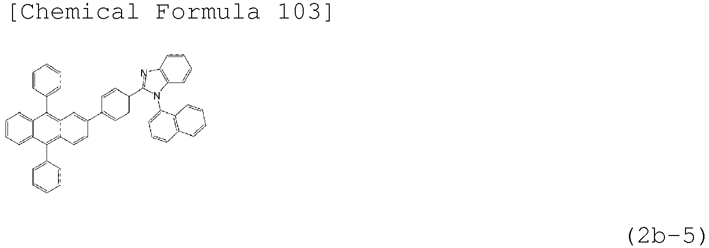

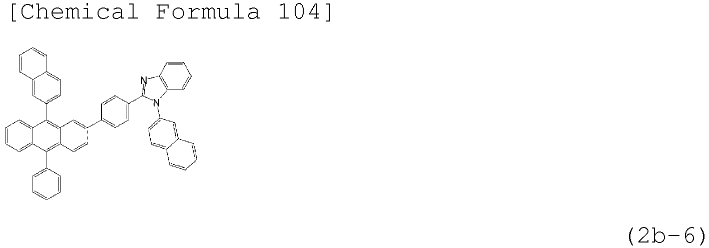

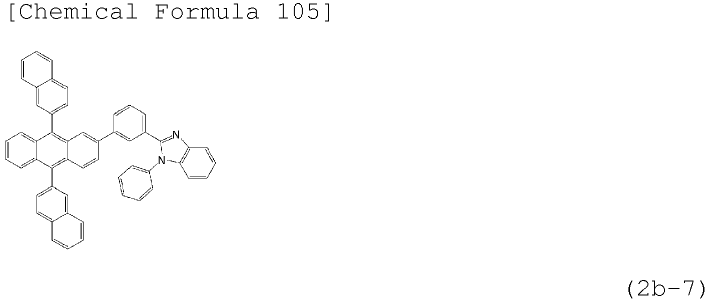

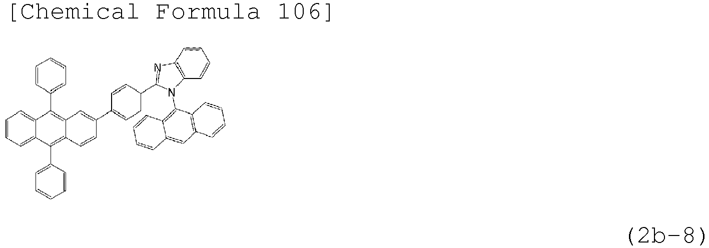

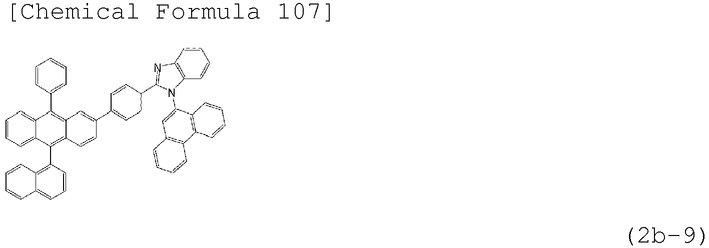

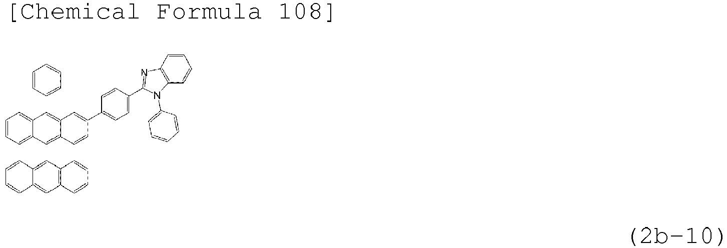

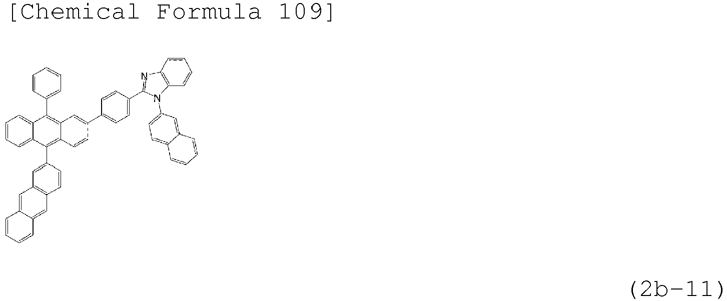

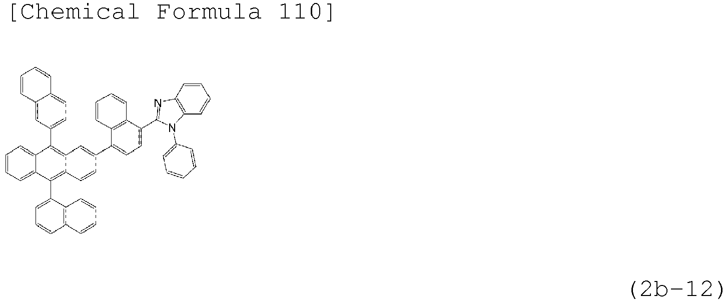

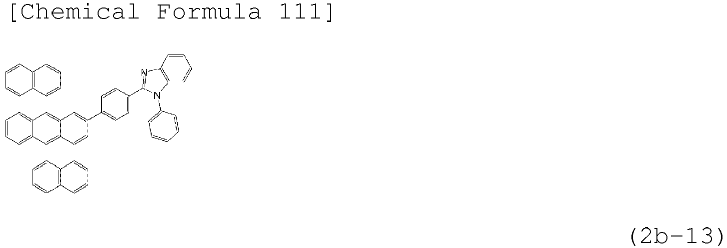

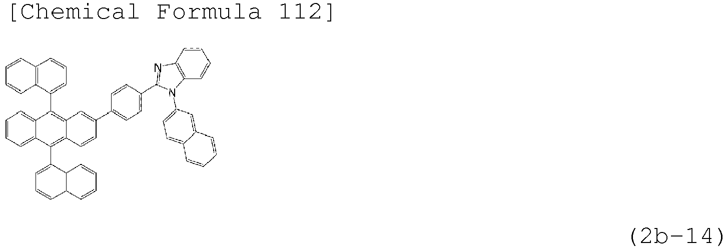

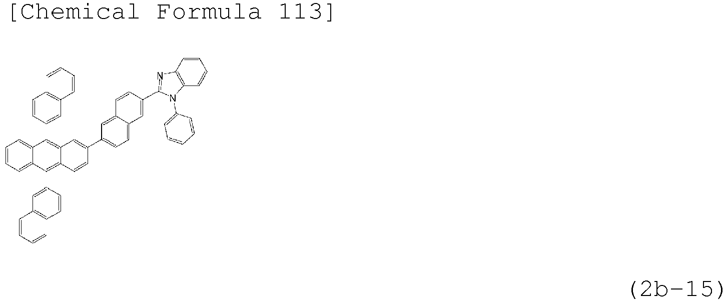

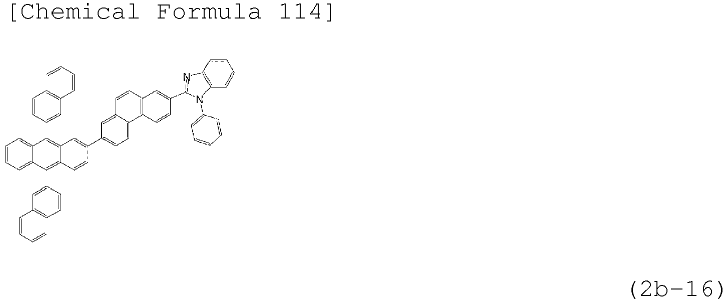

The following presents specific examples of preferred compounds among the compounds of the general formula (2c) preferably used in the organic EL device of the present invention and having an anthracene ring structure. The present invention, however, is not restricted to these compounds.

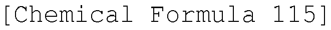

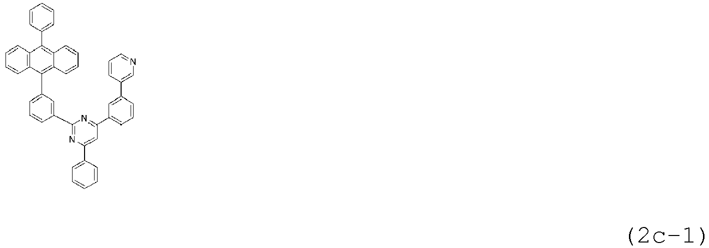

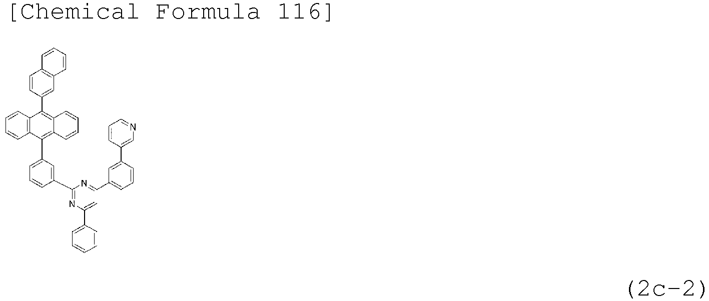

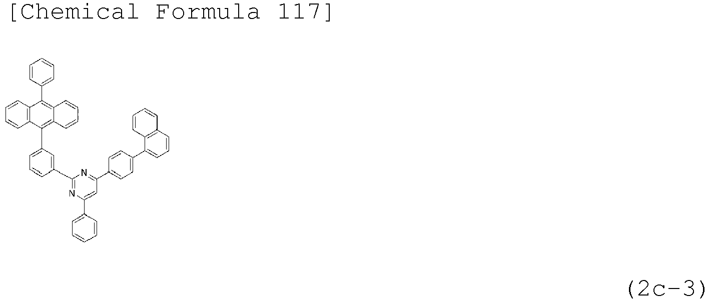

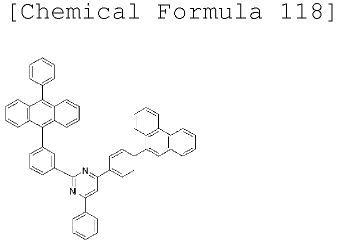

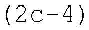

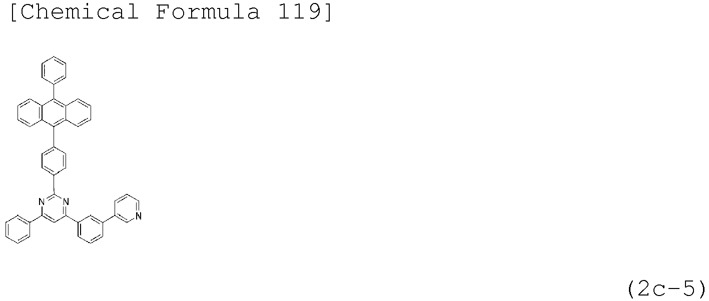

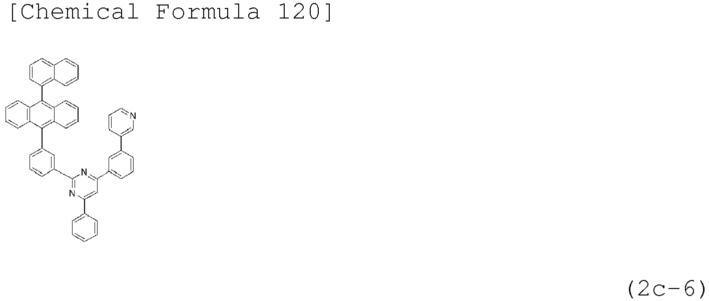

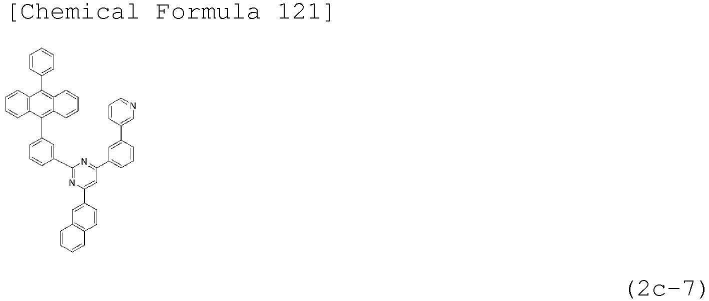

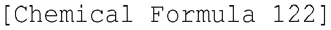

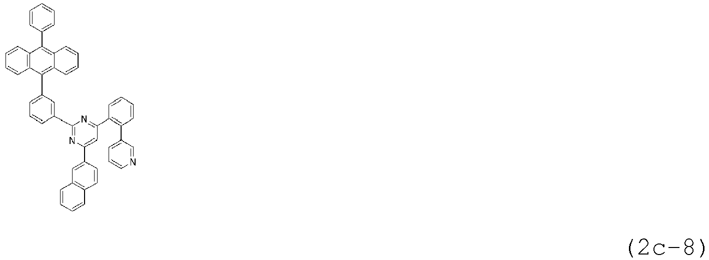

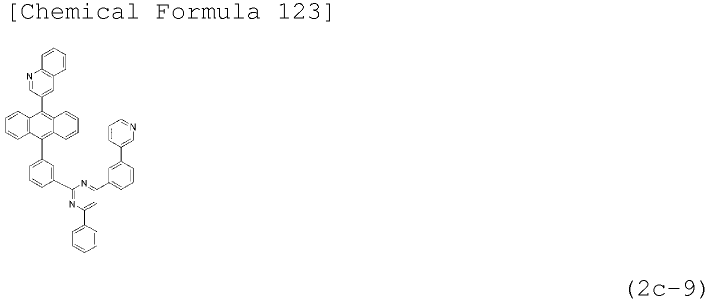

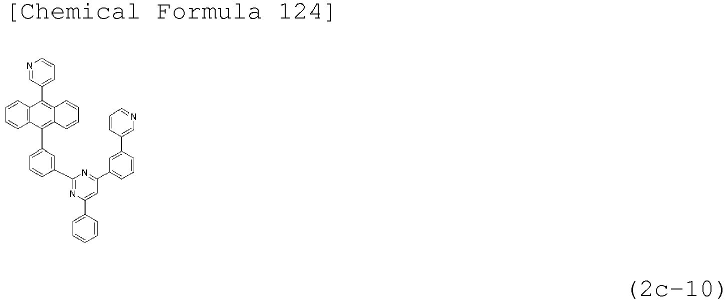

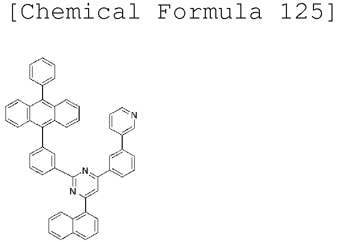

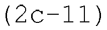

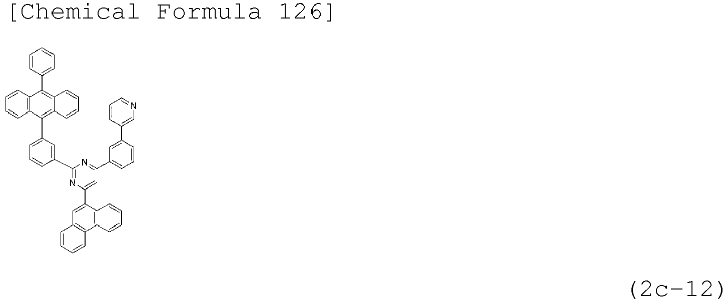

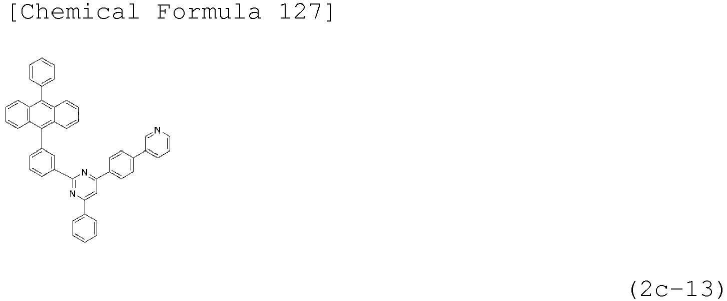

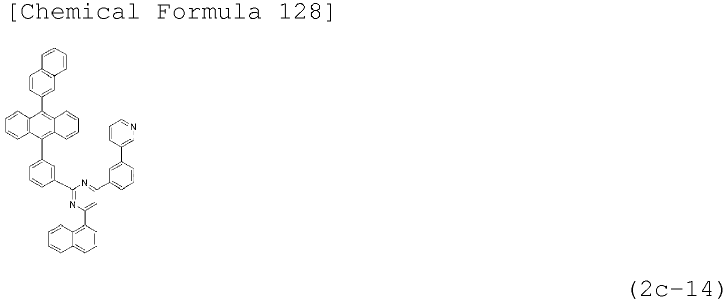

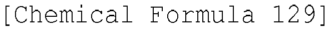

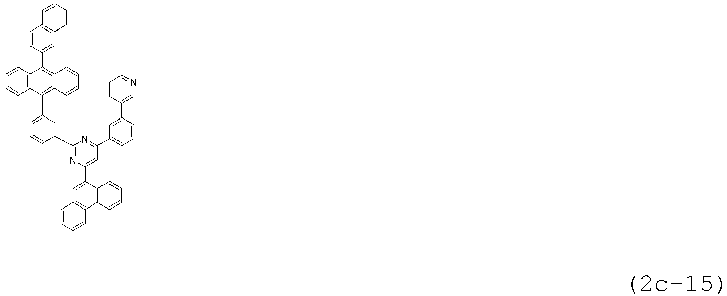

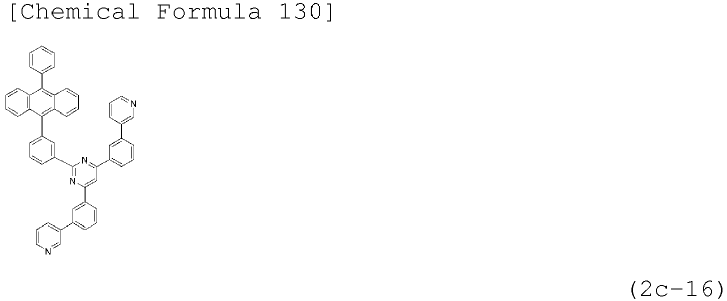

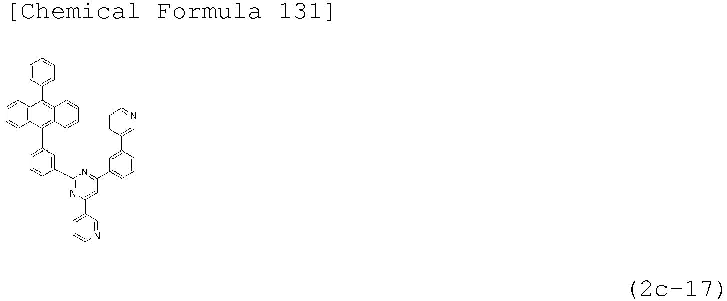

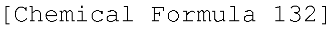

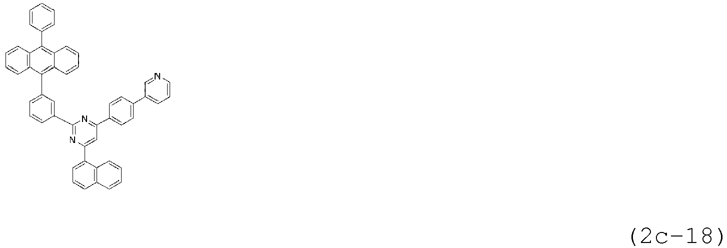

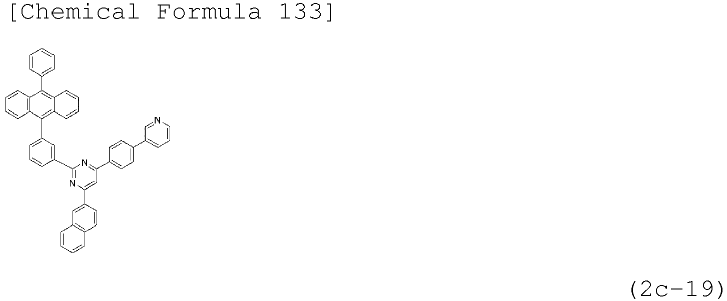

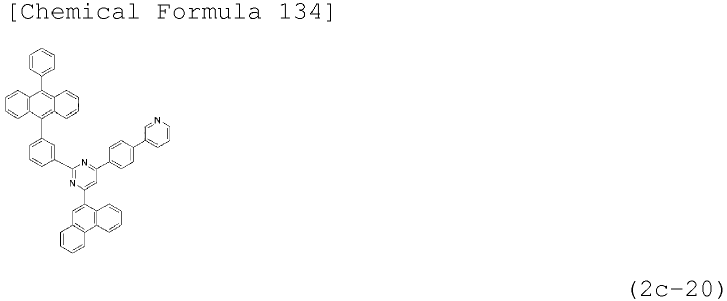

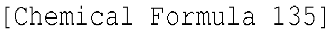

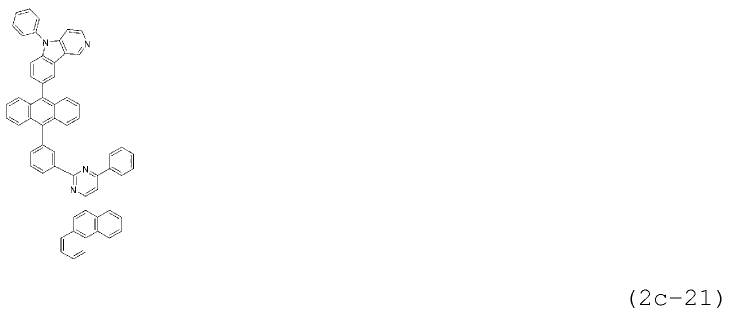

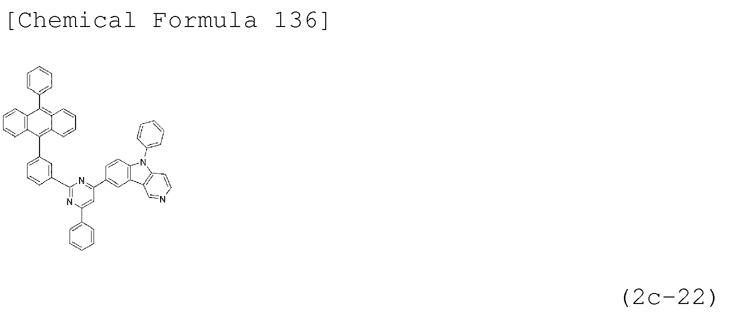

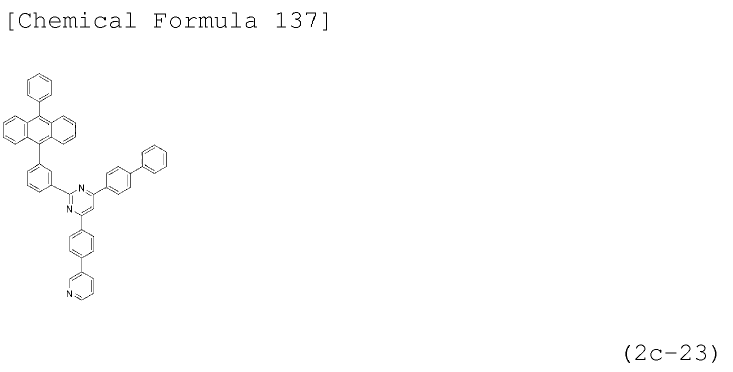

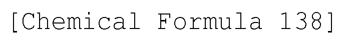

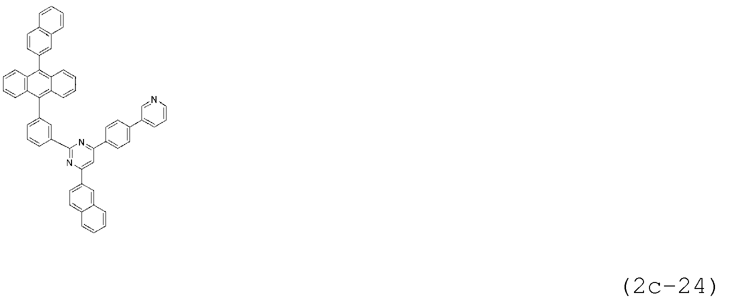

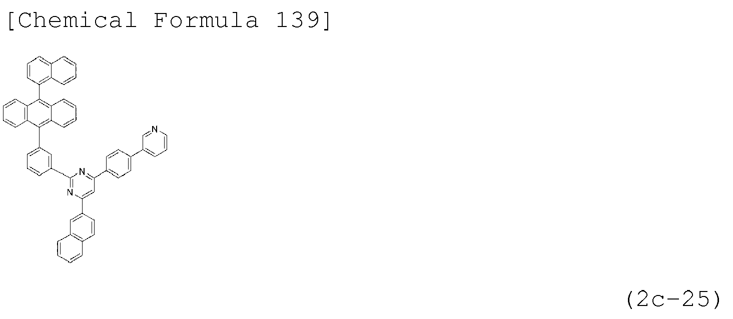

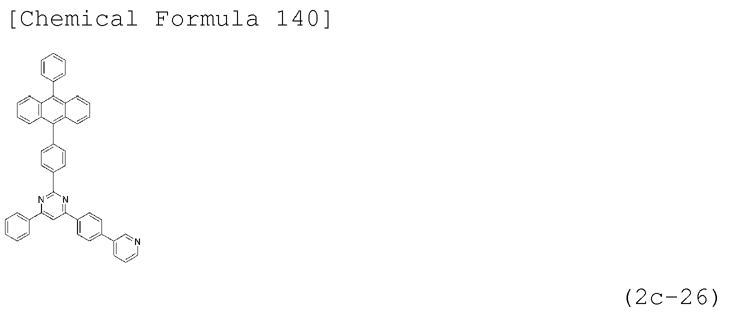

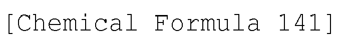

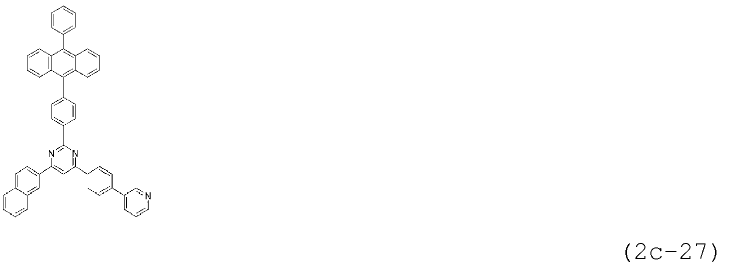

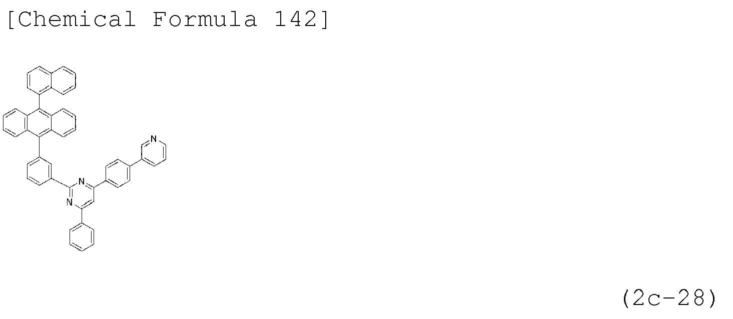

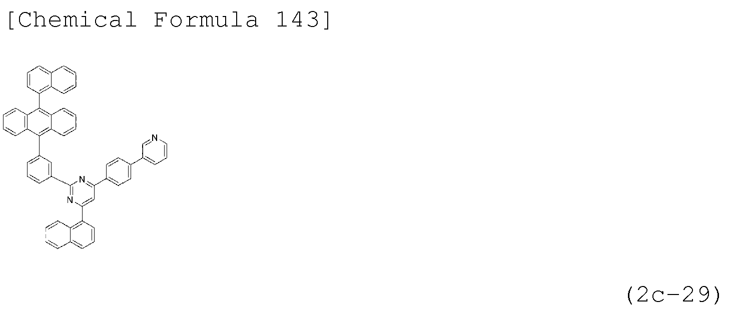

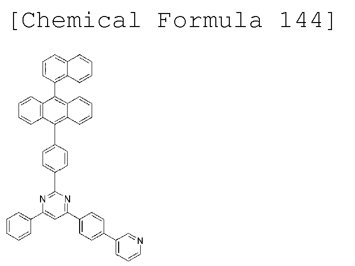

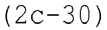

The compounds described above having an anthracene ring structure can be synthesized by a known method (refer to PTLs 4 to 6, for example).

The arylamine compounds of the general formula (1), the general formula (1a) and the general formula (1b) were purified by methods such as column chromatography, adsorption using, for example, a silica gel, activated carbon, or activated clay, recrystallization or crystallization using a solvent, and a sublimation purification method. The compounds were identified by an NMR analysis. A glass transition point (Tg) and a work function were measured as material property values. The glass transition point (Tg) can be used as an index of stability in a thin-film state, and the work function as an index of hole transportability.

Other compounds used for the organic EL device of the present invention were purified by methods such as column chromatography, adsorption using, for example, a silica gel, activated carbon, or activated clay, and recrystallization or crystallization using a solvent, and finally purified by sublimation.

The glass transition point (Tg) were measured by a high-sensitive differential scanning calorimeter (DSC3100S produced by Bruker AXS) using powder.

For the measurement of the work function, a 100 nm-thick thin film was fabricated on an ITO substrate, and an ionization potential measuring device (PYS-202 produced by Sumitomo Heavy Industries, Ltd.) was used.

The organic EL device of the present invention may have a structure including an anode, a hole injection layer, a hole transport layer, a light emitting layer, an electron transport layer, and a cathode successively formed on a substrate, optionally with an electron blocking layer between the hole transport layer and the light emitting layer, a hole blocking layer between the light emitting layer and the electron transport layer, and an electron injection layer between the electron transport layer and the cathode. Some of the organic layers in the multilayer structure may be omitted, or may serve more than one function. For example, a single organic layer may serve as the hole injection layer and the hole transport layer, or as the electron injection layer and the electron transport layer, and so on. Further, any of the layers may be configured to laminate two or more organic layers having the same function, and the hole transport layer may have a two-layer laminated structure, the light emitting layer may have a two-layer laminated structure, the electron transport layer may have a two-layer laminated structure, and so on.

Electrode materials with high work functions such as ITO and gold are used as the anode of the organic EL device of the present invention. As the hole injection layer of the organic EL device of the present invention, the arylamine compounds represented by the general formula (1) is preferably used. Other materials may be used including materials, such as a porphyrin compound represented by copper phthalocyanine, a starburst type triphenylamine derivative, and various triphenylamine tetramers, and an acceptor heterocyclic compound, such as hexacyanoazatriphenylene, and a coating type polymer material. These materials may be formed into a thin-film by a vapor deposition method or other known methods, such as a spin coating method and an inkjet method.

The arylamine compounds of the general formula (1) are used as the hole transport layer of the organic EL device of the present invention. These may be individually deposited for film forming, may be used as a single layer deposited mixed with other hole transporting materials, or may be formed as a laminate of individually deposited layers, a laminate of mixedly deposited layers, or a laminate of the individually deposited layer and the mixedly deposited layer. These materials may be formed into a thin-film by a vapor deposition method or other known methods such as a spin coating method and an inkjet method. Examples of a hole transporting material that can be mixed or can be used at the same time with the arylamine compounds of the general formula (1) can be benzidine derivatives such as NPD, N,N'-diphenyl-N,N'-di(m-tolyl)benzidine (TPD), and N,N,N',N'-tetrabiphenylylbenzidine; 1,1-bis[4-(di-4-tolylamino)phenyl]cyclohexane; and various triphenylamine trimers and tetramer. Examples of material used for the hole injection/transport layer can be coating-type polymer materials such as poly(3,4-ethylenedioxythiophene)/poly(styrenesulfonate) .

In the hole injection layer or the hole transport layer, a p-doped material of trisbromophenylaminehexachloroantimony, a radialene derivative (refer to, for example, WO 2014/009310), or the like, a polymer compound having a structure of a benzidine derivative, such as TPD, as a partial structure thereof, or the like may be used with the material that is ordinarily used in the layer.

Examples of material used for the electron blocking layer of the organic EL device of the present invention can be preferably the arylamine compounds represented by the general formula (1). Other examples of the material may be a compound having an electron blocking capability, such as a carbazole derivative, such as 4,4',4"-tri(N-carbazolyl)triphenylamine (TCTA), 9,9-bis[4-(carbazol-9-yl)phenyl]fluorene, 1,3-bis(carbazol-9-yl)benzene (mCP), and 2,2-bis(4-carbazol-9-ylphenyl)adamantane (Ad-Cz), a compound having a triphenylsilyl group and a triarylamine structure, represented by 9-[4-(carbazol-9-yl)phenyl]-9-[4-(triphenylsilyl)phenyl]-9H-fluorene. These compounds each may be individually formed into a film, may be formed into a single layer with another material mixed, or may be formed into a laminated structure containing the individually formed layers, a laminated structure containing the layers with another material mixed, or a laminated structure containing the individually formed layer and the layer with another material mixed. These materials may be formed into a thin film by a vapor deposition method or other known methods such as a spin coating method and an inkjet method.

Examples of material used for the light emitting layer of the organic EL device of the present invention can be various metal complexes, anthracene derivatives, bis(styryl)benzene derivatives, pyrene derivatives, oxazole derivatives, and polyparaphenylene vinylene derivatives, in addition to quinolinol derivative metal complexes such as Alq₃. Further, the light emitting layer may be made of a host material and a dopant material. Examples of the host material can be preferably the arylamine compounds represented by the general formula (1) and anthracene derivatives. Other examples of the host material can be heterocyclic compounds having indole ring as a part of a condensed ring, heterocyclic compounds having carbazole ring as a part of a condensed ring, carbazole derivatives, thiazole derivatives, benzimidazole derivatives, and polydialkyl fluorene derivatives, in addition to the above light-emitting materials. Examples of the dopant material can be preferably pyrene derivatives. Other examples of the dopant material can be amine derivatives having fluorene ring as a part of a condensed ring, quinacridone, coumarin, rubrene, perylene, derivatives thereof, benzopyran derivatives, indenophenanthrene derivatives, rhodamine derivatives, and aminostyryl derivatives. These may be individually deposited for film forming, may be used as a single layer deposited mixed with other materials, or may be formed as a laminate of individually deposited layers, a laminate of mixedly deposited layers, or a laminate of the individually deposited layer and the mixedly deposited layer.

Further, the light-emitting material may be a phosphorescent material. Phosphorescent materials as metal complexes of metals such as iridium and platinum may be used. Examples of the phosphorescent materials include green phosphorescent materials such as Ir(ppy)₃, blue phosphorescent materials such as FIrpic and FIr₆, and red phosphorescent materials such as Btp₂Ir(acac). Here, carbazole derivatives such as 4,4'-di(N-carbazolyl)biphenyl, TCTA, mCP and the arylamine compounds of the general formula (1) may be used as the hole injecting and transporting host material. Compounds such as p-bis(triphenylsilyl)benzene and 2,2',2"-(1,3,5-phenylene)-tris(1-phenyl-1H-benzimidazole) may be used as the electron transporting host material. In this way, a high-performance organic EL device can be produced.

In order to avoid concentration quenching, the doping of the host material with the phosphorescent light-emitting material should preferably be made by co-evaporation in a range of 1 to 30 weight percent with respect to the whole light emitting layer.

Further, examples of the light-emitting material may be delayed fluorescent-emitting material such as a CDCB derivative of PIC-TRZ, CC2TA, PXZ-TRZ, 4CzIPN or the like (refer to NPL 3, for example).

These materials may be formed into a thin-film by using a vapor deposition method or other known methods such as a spin coating method and an inkjet method.

The hole blocking layer of the organic EL device of the present invention may be formed by using hole blocking compounds such as various rare earth complexes, triazole derivatives, triazine derivatives, and oxadiazole derivatives, in addition to phenanthroline derivatives such as bathocuproin, and the metal complexes of quinolinol derivatives such as aluminum(III) bis(2-methyl-8-quinolinate)-4-phenylphenolate (BAlq). These materials may also serve as the material of the electron transport layer. These may be individually deposited for film forming, may be used as a single layer deposited mixed with other materials, or may be formed as a laminate of individually deposited layers, a laminate of mixedly deposited layers, or a laminate of the individually deposited layer and the mixedly deposited layer. These materials may be formed into a thin-film by using a vapor deposition method or other known methods such as a spin coating method and an inkjet method.

Material used for the electron transport layer of the organic EL device of the present invention can be the compounds of the general formula (2) having an anthracene ring structure, far preferably, the compounds of the general formulas (2a), (2b), or (2c) having an anthracene ring structure. These may be individually deposited for film forming, may be used as a single layer deposited mixed with other electron transporting materials, or may be formed as a laminate of individually deposited layers, a laminate of mixedly deposited layers, or a laminate of the individually deposited layer and the mixedly deposited layer. These materials may be formed into a thin film by a vapor deposition method or other known methods such as a spin coating method and an inkjet method.

Examples of the electron transporting material that can be mixed or can be used at the same time with the compound represented by the general formula (2) having an anthracene ring structure can be various metal complexes, including, for example, metal complexes of quinolinol derivatives such as Alq₃ and BAlq, triazole derivatives, triazine derivatives, oxadiazole derivatives, pyridine derivatives, pyrimidine derivatives, benzimidazole derivatives, thiadiazole derivatives, anthracene derivatives, carbodiimide derivatives, quinoxaline derivatives, pyridoindole derivatives, phenanthroline derivatives, and silole derivatives.

Examples of material used for the electron injection layer of the organic EL device of the present invention can be alkali metal salts such as lithium fluoride and cesium fluoride; alkaline earth metal salts such as magnesium fluoride; and metal oxides such as aluminum oxide. However, the electron injection layer may be omitted in the preferred selection of the electron transport layer and the cathode.

The cathode of the organic EL device of the present invention may be made of an electrode material with a low work function such as aluminum, or an alloy of an electrode material with an even lower work function such as a magnesium-silver alloy, a magnesium-indium alloy, or an aluminum-magnesium alloy.

The following describes an embodiment of the present invention in more detail based on Examples. The present invention, however, is not restricted to the following Examples.

### Example 1

### <Synthesis of N,N'-bis(4'-diphenylamino-biphenyl-4-yl)-N,N'-diphenyl-dibenzofuran-2,8-diamine (Compound 2)>

2,8-dibromodibenzofuran (3.0 g), (4'-diphenylamino-biphenyl-4-yl)- phenylamine (8.4 g), sodium tert-butoxide (2.7 g), and toluene (60 ml) were added into a reaction vessel in a nitrogen atmosphere. The mixture was heated after adding tert-butylphosphine (0.2 g) and tris(dibenzylideneacetone)dipalladium (Pd₂(dba)₃) (0.2g), and heated to reflux for 10 hours while being stirred. The mixture was filtered after adding a toluene (30 ml), and the filtrate was concentrated. The crude product was purified by column chromatography (support: silica gel, eluent: toluene / cyclohexane), and through crystallization with a mixed solvent of butyl acetate and n-hexane to obtain a pale yellow powder of N,N'-bis(4'-diphenylamino-biphenyl-4-yl)-N,N'-diphenyl-dibenzofuran-2,8-diamine (Compound 2; 7.6 g; yield 83.5 %).

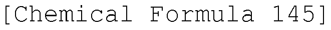

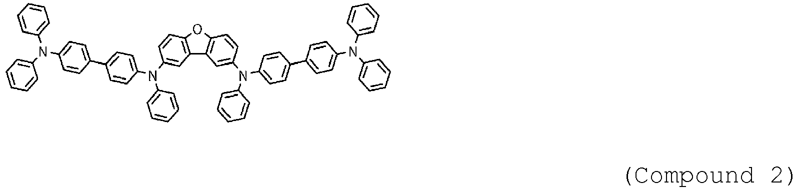

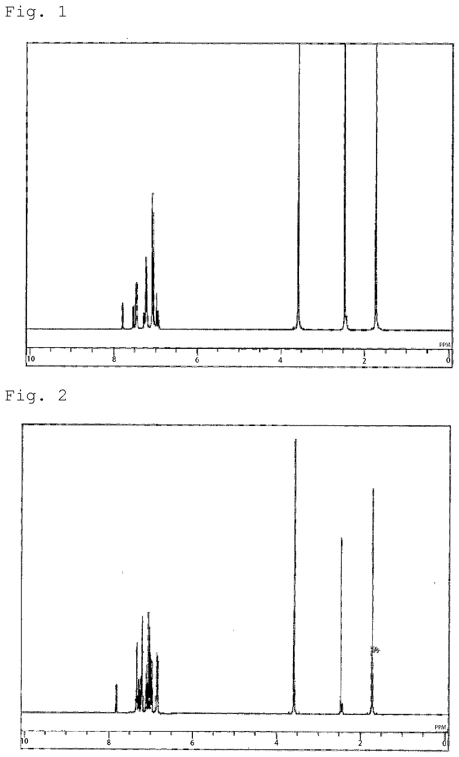

The structure of the obtained pale yellow powder was identified by NMR. The ¹H-NMR measurement result is presented in FIG. 1.

¹H-NMR (THF-d₈) detected 52 hydrogen signals, as follows.
δ (ppm) = 7.78 (2H), 7.53 (2H), 7.45 (8H), 7.27 (2H), 7.24-7.19 (12H), 7.07 (20H), 6.98 (4H), 6.93 (2H).

### Example 2

### <Synthesis of N,N'-bis(4'-diphenylamino-biphenyl-4-yl)-N,N'-diphenyl-dibenzofuran-4,6-diamine (Compound 33)>

4,6-diiododibenzofuran (5.0 g), (4'-diphenylamino-biphenyl-4-yl)- phenylamine (11.8 g), potassium carbonate (4.9 g), Sodium hydrogen sulfite (0.4 g), 3,5-di-tert-butylsalicylic acid (0.3 g), xylene (10 ml), dodecylbenzene (5 ml) and a copper powder (0.1 g) were added into a reaction vessel in a nitrogen atmosphere. The mixture was heated and stirred at 210°C for 12 hours. The mixture was filtered after adding a toluene (60 ml), and the filtrate was concentrated. The crude product was purified by column chromatography (support: silica gel, eluent: toluene / cyclohexane), and through crystallization with a mixed solvent of butyl acetate and n-hexane to obtain a white powder of N,N'-bis(4'-diphenylamino-biphenyl-4-yl)-N,N'-diphenyl-dibenzofuran-4,6-diamine (Compound 33; 9.3 g; yield 78.9 %).

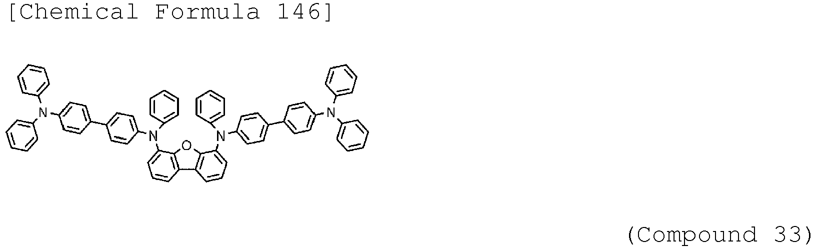

The structure of the obtained pale yellow powder was identified by NMR. The ¹H-NMR measurement result is presented in FIG. 2.

¹H-NMR (THF-d₈) detected 52 hydrogen signals, as follows.
δ (ppm) = 7.82 (2H), 7.33 (8H), 7.29 (2H), 7.23 (2H), 7.20 (8H), 7.10 (4H), 7.04 (8H), 6.99 (4H), 6.96 (4H), 6.87-6.82 (10H).

### Example 3

### <Synthesis of N,N'-bis(4'-diphenylamino-biphenyl-4-yl)-N,N'-diphenyl-dibenzothiophene-2,8-diamine (Compound 56) >

2,8-dibromodibenzothiophene (5.0 g), (4'-diphenylamino-biphenyl-4-yl)-phenylamine (13.3 g), sodium tert-butoxide (4.2 g), and toluene (100 ml) were added into a reaction vessel in a nitrogen atmosphere. The mixture was heated after adding tert-butylphosphine (0.3 g) and Tris(dibenzylideneacetone)dipalladium(0) (0.3 g), and stirred for 5.5 hours under reflux. The mixture was cooled to a room temperature after water (50 ml) was added, and the precipitated crude product was collected by filtration. The filtrate was purified by recrystallization with dichlorobenzene to obtain a pale yellow powder of N,N'-bis(4'-diphenylamino-biphenyl-4-yl)-N,N'-diphenyl-dibenzothiophene-2,8-diamine (Compound 56; 11.3 g; yield 76.9 %).

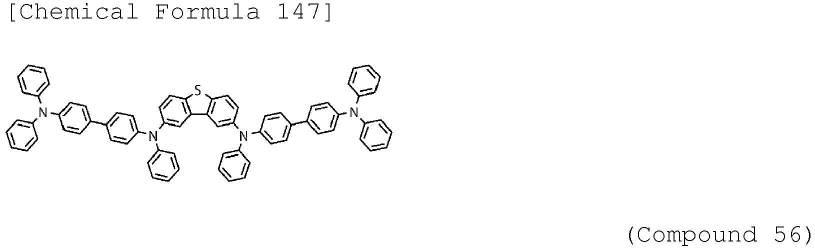

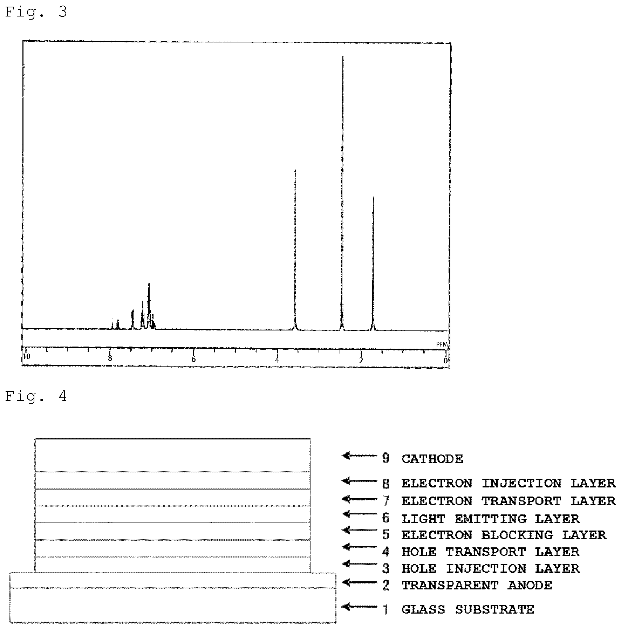

The structure of the obtained white powder was identified by NMR. The ¹H-NMR measurement result is presented in FIG. 3.

¹H-NMR (THF-d₈) detected 52 hydrogen signals, as follows.
δ (ppm) = 7.94 (2H), 7.81 (2H), 7.46 (4H), 7.45 (4H), 7.25-7.19 (14H), 7.08-7.05 (20H), 6.98 (4H), 6.94(2H).

### Example 4

The glass transition points of the arylamine compounds of the general formula (1) were measured using a high-sensitive differential scanning calorimeter (DSC3100S produced by Bruker AXS).

| | Glass transition point |
|---|---|
| Compound of Example 1(Compound 2) | 151.9 °C |
| Compound of Example 2(Compound 33) | 131.1 °C |
| Compound of Example 3(Compound 56) | 150.8 °C |

The arylamine compounds of the general formula (1) have glass transition points of 100°C or higher, especially 130°C or higher, demonstrating that the arylamine compounds of the general formula (1) have a stable thin-film state.

### Example 5

A 100 nm-thick vapor-deposited film was fabricated on an ITO substrate using the arylamine compounds of the general formula (1), and a work function was measured using an ionization potential measuring device (PYS-202 produced by Sumitomo Heavy Industries, Ltd.).

| | Work function |
|---|---|
| Compound of Example 1(Compound 2) | 5.58 eV |
| Compound of Example 2(Compound 33) | 5.60 eV |
| Compound of Example 3(Compound 56) | 5.55 eV |

As the results show, the arylamine compounds of the general formula (1) have desirable energy levels compared to the work function 5.5 eV of common hole transport materials such as NPD and TPD, and thus possess desirable hole transportability.

### Example 6

The organic EL device, as illustrated in FIG. 4, was fabricated from a hole injection layer 3, a hole transport layer 4, an electron blocking layer 5, a light emitting layer 6, an electron transport layer 7, an electron injection layer 8, and a cathode (aluminum electrode) 9 successively formed by vapor deposition on a glass substrate 1 that had been provided beforehand with an ITO electrode as a transparent anode 2.

Specifically, the glass substrate 1 having ITO (thickness 50 nm) formed thereon was washed with an organic solvent, and subjected to a UV ozone treatment to wash the surface. The glass substrate with the ITO electrode was then installed in a vacuum vapor deposition apparatus, and the pressure was reduced to 0.001 Pa or less. This was followed by formation of the hole injection layer 3 by forming Compound (HIM-1) of the structural formula below over the transparent anode 2 in a thickness of 5 nm. The hole transport layer 4 was then formed on the hole injection layer 3 by forming the compound of Example 1 of the present invention (Compound 2) in a thickness of 65 nm. Then, the electron blocking layer 5 was formed on the hole transport layer 4 by forming Compound (EBM-1) of the structural formula below in a thickness of 5 nm. The light emitting layer 6 was formed on the electron blocking layer 5 in a thickness of 20 nm by the dual vapor deposition of the pyrene derivative (EMD-1) of the structural formula below and the anthracene derivative (EMH-1) of the structural formula below at a deposition rate ratio of EMD-1/EMH-1 = 5/95. The electron transport layer 7 was formed on the light emitting layer 6 in a thickness of 30 nm by the dual vapor deposition of Compound (2b-1) having an anthracene ring structure of the structural formula below and Compound (ETM-1) of the structural formula below at a deposition rate ratio of Compound 2b-1/ETM-1 = 50/50. The electron injection layer 8 was formed on the electron transport layer 7 by forming Compound (ETM-1) of the structural formula below in a thickness of 1 nm. Finally, the cathode 9 was formed by vapor depositing aluminum in a thickness of 100 nm. The glass substrate having the organic film and aluminum formed thereon was transferred to a glove box substituted with dry nitrogen, and a sealing glass substrate was adhered with a UV-curable resin, so as to provide an organic EL device. The characteristics of the organic EL device thus fabricated were measured in an atmosphere at ordinary temperature. Table 1 summarizes the results of the emission characteristics measurements performed by applying a DC voltage to the organic EL device.

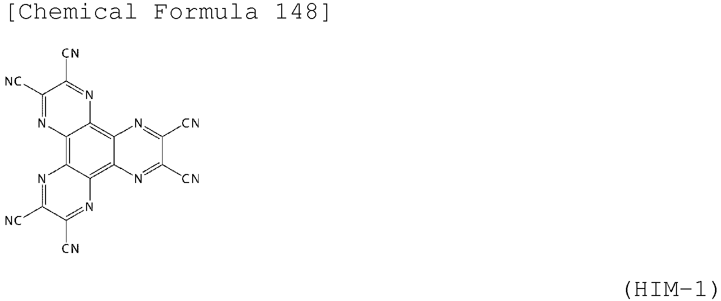

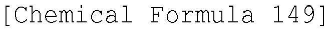

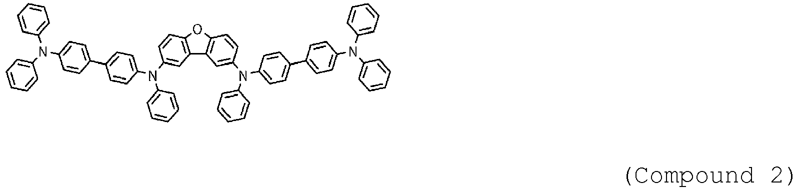

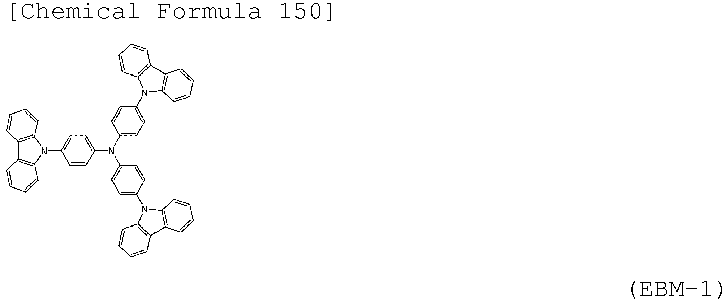

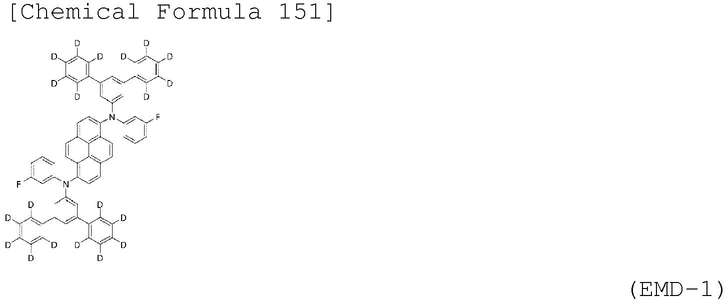

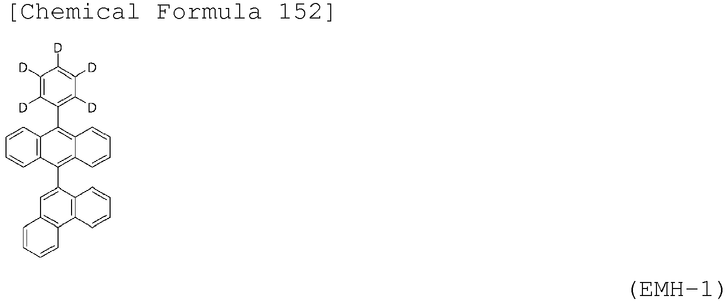

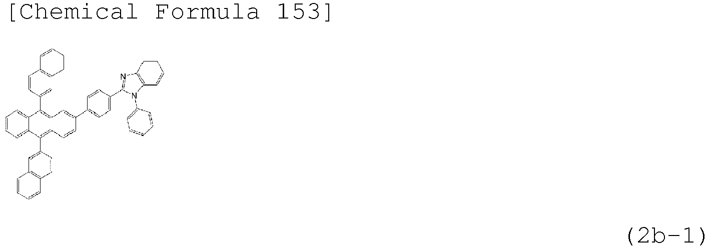

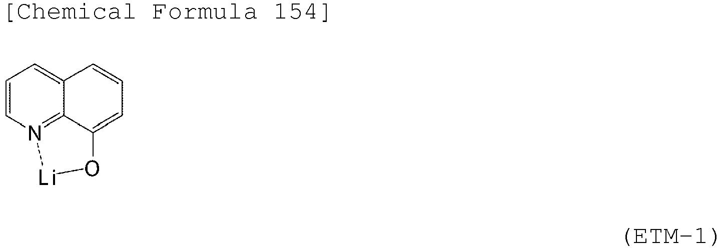

### Example 7

An organic EL device was fabricated under the same conditions used in Example 6, except that the compound (Compound 2) of Example 1 was replaced with compound (Compound 33) of Example 2 as material of the hole transport layer 4. The characteristics of the organic EL device thus fabricated were measured in the atmosphere at an ordinary temperature. Table 1 summarizes the results of emission characteristics measurements performed by applying a DC voltage to the fabricated organic EL device.

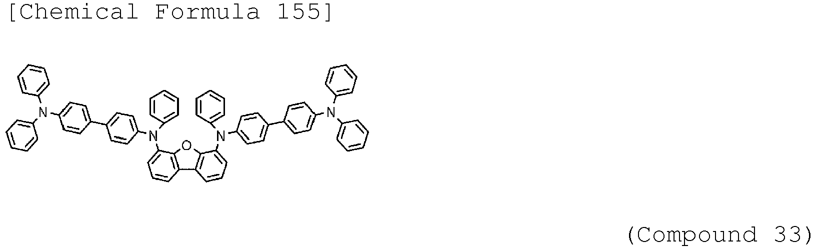

### Example 8

An organic EL device was fabricated under the same conditions used in Example 6, except that the compound (Compound 2) of Example 1 was replaced with compound (Compound 56) of Example 3 as material of the hole transport layer 4. The characteristics of the organic EL device thus fabricated were measured in the atmosphere at an ordinary temperature. Table 1 summarizes the results of emission characteristics measurements performed by applying a DC voltage to the fabricated organic EL device.

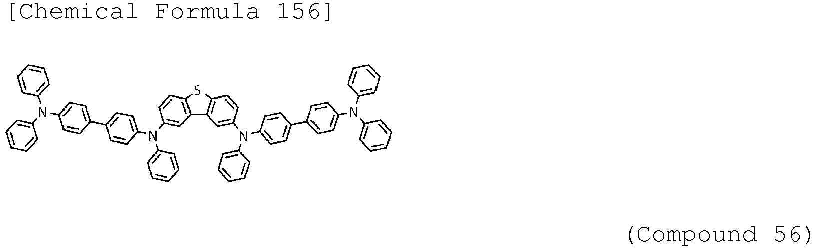

### Comparative Example 1

For comparison, an organic EL device was fabricated under the same conditions used in Example 6, except that the compound of Example 1 (Compound 2) was replaced with Compound (HTM-1) of the structural formula below as material of the hole transport layer 4. The characteristics of the organic EL device thus fabricated were measured in an atmosphere at ordinary temperature. Table 1 summarizes the results of the emission characteristics measurements performed by applying a DC voltage to the organic EL device.

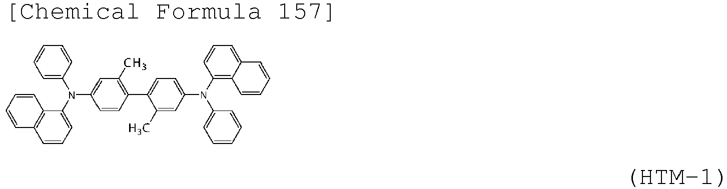

Table 1 summarizes the results of measurement of a device lifetime using the organic EL devices fabricated in Examples 6 to 8 and Comparative Examples 1. The device lifetime was measured as a time elapsed until the emission luminance of 2,000 cd/m² (initial luminance) at the start of emission was attenuated to 1,900 cd/m² (corresponding to 95% when taking the initial luminance as 100%: Attenuation to 95%) when carrying out constant current driving.

**[Table 1]**

| | Compound | Voltage [V] (@ 10mA/cm²) | Luminance [cd/m²] (@ 10mA/cm²) | Luminous efficiency [cd/A] (@ 10mA/cm²) | Power efficiency [lm/W] (@ 10mA/cm²) | Lifetime of device, attenulation to 95% |
|---|---|---|---|---|---|---|
| Example 6 | Compound 2 | 3.91 | 659 | 6.59 | 5.29 | 218 hours |
| Example 7 | Compound 33 | 4.20 | 613 | 6.13 | 4.59 | 231 hours |
| Example 8 | Compound 56 | 4.22 | 615 | 6.15 | 4.58 | 247 hours |
| Comparative Example 1 | HTM-1 | 4.37 | 482 | 4.82 | 3.46 | 135 hours |

As shown in Table 1, it was understood as follows. The driving voltage with a current having a current density of 10 mA/cm² applied was decreased to 3.91 to 4.22 V in the organic EL devices of Examples 6 to 8, as compared to 4.37 V in the organic EL device of Comparative Example 1. The luminous efficiency was increased to 6.13 to 6.59 cd/A in the organic EL devices of Examples 6 to 8, as compared to 4.82 cd/A in the organic EL device of Comparative Example 1. The power efficiency was also largely increased to 4.58 to 5.29 lm/W in the organic EL devices of Examples 6 to 8, as compared to 3.46 lm/W in the organic EL device of Comparative Example 1. Furthermore, the lifetime of the device (attenuation to 95%) was largely increased to 218 to 247 hours in the organic EL devices of Examples 6 to 8, as compared to 135 hours in the organic EL device of Comparative Example 1.

As is clear from these results, the organic EL devices using the arylamine compounds of the general formula (1) can achieve a low driving voltage, High luminous efficiency and a long lifetime compared to the organic EL device that uses known HTM-1.

### Industrial Applicability

The arylamine compounds of the general formula (1) have a high hole transportability, an excellent electron blocking ability, and a stable thin-film state, and are desirable for organic EL devices. The organic EL device produced by using the compounds can have high luminous efficiency and high power efficiency, and a low actual driving voltage, and can thus have improved durability. There are potential applications for, for example, home electronic appliances and illuminations.

### Reference Signs List

- 1: Glass substrate
- 2: Transparent anode
- 3: Hole injection layer
- 4: Hole transport layer
- 5: Electron blocking layer
- 6: Light emitting layer
- 7: Electron transport layer
- 8: Electron injection layer
- 9: Cathode

## Claims

1. An organic electroluminescent device comprising at least an anode, a hole transport layer, a light emitting layer, an electron transport layer, and a cathode in this order, wherein the hole transport layer comprises an arylamine compound of the following general formula (1): 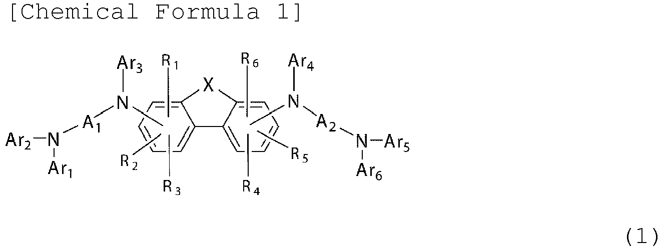 wherein Ar₁ to Ar₆ may be the same or different, and represent a substituted or unsubstituted aromatic hydrocarbon group, a substituted or unsubstituted aromatic heterocyclic group, or a substituted or unsubstituted condensed polycyclic aromatic group, and A₁ and A₂ may be the same or different, and represent a divalent group of a substituted or unsubstituted aromatic hydrocarbon, a divalent group of a substituted or unsubstituted aromatic heterocyclic ring, a divalent group of a substituted or unsubstituted condensed polycyclic aromatic, and R₁ to R₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy, and X represents an oxygen atom or a sulfur atom.

2. The organic electroluminescent device according to claim 1, wherein the arylamine compound is an arylamine compound of the following general formula (1a): 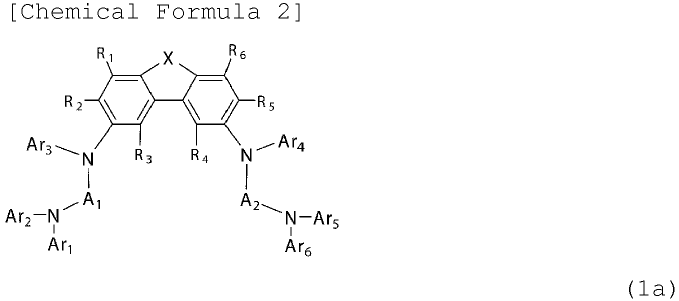 wherein Ar₁ to Ar₆ may be the same or different, and represent a substituted or unsubstituted aromatic hydrocarbon group, a substituted or unsubstituted aromatic heterocyclic group, or a substituted or unsubstituted condensed polycyclic aromatic group, and A₁ and A₂ may be the same or different, and represent a divalent group of a substituted or unsubstituted aromatic hydrocarbon, a divalent group of a substituted or unsubstituted aromatic heterocyclic ring, a divalent group of a substituted or unsubstituted condensed polycyclic aromatic, and R₁ to R₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy, and X represents an oxygen atom or a sulfur atom.

3. The organic electroluminescent device according to claim 1, wherein the arylamine compound is an arylamine compound of the following general formula (1b): 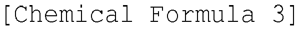 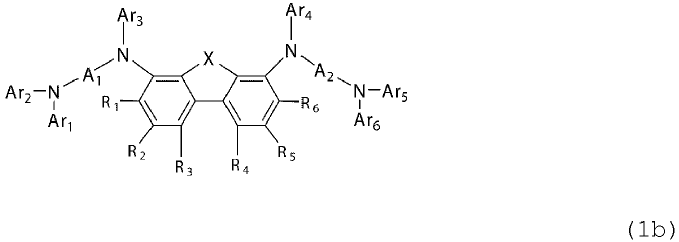 wherein Ar₁ to Ar₆ may be the same or different, and represent a substituted or unsubstituted aromatic hydrocarbon group, a substituted or unsubstituted aromatic heterocyclic group, or a substituted or unsubstituted condensed polycyclic aromatic group, and A₁ and A₂ may be the same or different, and represent a divalent group of a substituted or unsubstituted aromatic hydrocarbon, a divalent group of a substituted or unsubstituted aromatic heterocyclic ring, a divalent group of a substituted or unsubstituted condensed polycyclic aromatic, and R₁ to R₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy, and X represents an oxygen atom or a sulfur atom.

4. The organic electroluminescent device according to any one of claims 1 to 3, wherein the electron transport layer comprises a compound of the following general formula (2) having an anthracene ring structure: 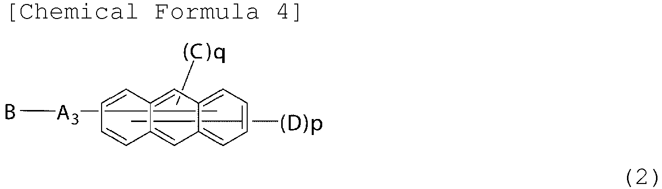 wherein A₃ represents a divalent group of a substituted or unsubstituted aromatic hydrocarbon, a divalent group of a substituted or unsubstituted aromatic heterocyclic ring, a divalent group of a substituted or unsubstituted condensed polycyclic aromatic, or a single bond; B represents a substituted or unsubstituted aromatic heterocyclic group; C represents a substituted or unsubstituted aromatic hydrocarbon group, a substituted or unsubstituted aromatic heterocyclic group, or a substituted or unsubstituted condensed polycyclic aromatic group; D may be the same or different, and represents a hydrogen atom, a deuterium atom, a fluorine atom, a chlorine atom, cyano, trifluoromethyl, linear or branched alkyl of 1 to 6 carbon atoms, a substituted or unsubstituted aromatic hydrocarbon group, a substituted or unsubstituted aromatic heterocyclic group, or a substituted or unsubstituted condensed polycyclic aromatic group; and while p and q maintain a relationship that the sum of p and q is 9, p represents 7 or 8, and q represents 1 or 2.

5. The organic electroluminescent device according to claim 4, wherein the compound having an anthracene ring structure is a compound of the following general formula (2a) having an anthracene ring structure: 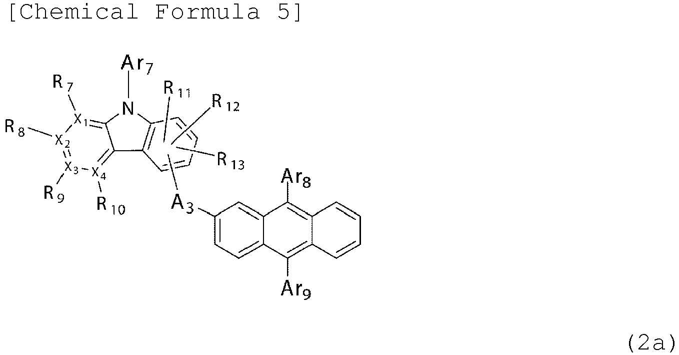 wherein A₃ represents a divalent group of a substituted or unsubstituted aromatic hydrocarbon, a divalent group of a substituted or unsubstituted aromatic heterocyclic ring, a divalent group of a substituted or unsubstituted condensed polycyclic aromatic, or a single bond, and Ar₇, Ar₈, and Ar₉ may be the same or different, and represent a substituted or unsubstituted aromatic hydrocarbon group, a substituted or unsubstituted aromatic heterocyclic group, or a substituted or unsubstituted condensed polycyclic aromatic group; R₇ to R₁₃ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy, and may bind to each other via a single bond, substituted or unsubstituted methylene, an oxygen atom, or a sulfur atom to form a ring; and X₁, X₂, X₃, and X₄ represent a carbon atom or a nitrogen atom, where only one of X₁, X₂, X₃, and X₄ is a nitrogen atom, and, in this case, the nitrogen atom does not have the hydrogen atom or substituent for R₇ to R₁₀.

6. The organic electroluminescent device according to claim 4, wherein the compound having an anthracene ring structure is a compound of the following general formula (2b) having an anthracene ring structure: 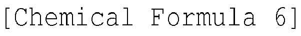 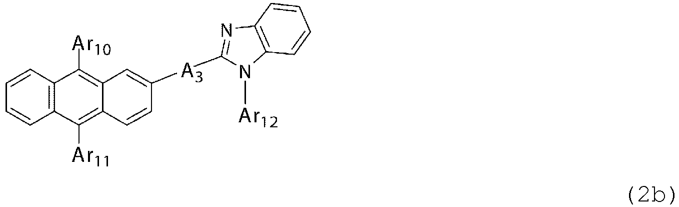 wherein A₃ represents a divalent group of a substituted or unsubstituted aromatic hydrocarbon, a divalent group of a substituted or unsubstituted aromatic heterocyclic ring, a divalent group of a substituted or unsubstituted condensed polycyclic aromatic, or a single bond, and Ar₁₀, Ar₁₁, and Ar₁₂ may be the same or different, and represent a substituted or unsubstituted aromatic hydrocarbon group, a substituted or unsubstituted aromatic heterocyclic group, or a substituted or unsubstituted condensed polycyclic aromatic group.

7. The organic electroluminescent device according to claim 4, wherein the compound having an anthracene ring structure is a compound of the following general formula (2c) having an anthracene ring structure: 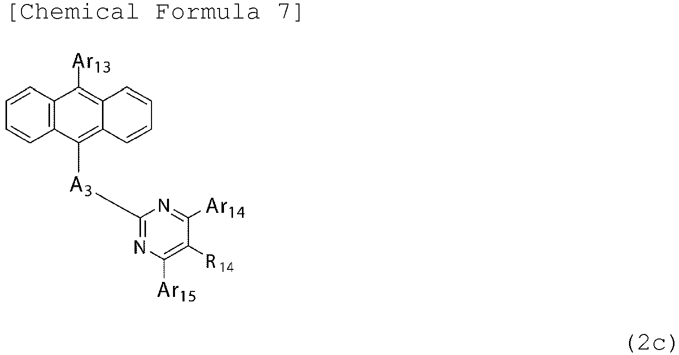 wherein A₃ represents a divalent group of a substituted or unsubstituted aromatic hydrocarbon, a divalent group of a substituted or unsubstituted aromatic heterocyclic ring, a divalent group of a substituted or unsubstituted condensed polycyclic aromatic, or a single bond, and Ar₁₃, Ar₁₄, and Ar₁₅ may be the same or different, and represent a substituted or unsubstituted aromatic hydrocarbon group, a substituted or unsubstituted aromatic heterocyclic group, or a substituted or unsubstituted condensed polycyclic aromatic group; R₁₄ represents a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy.

8. The organic electroluminescent device according to any one of claims 1 to 7, wherein the light emitting layer includes a blue light emitting dopant.

9. The organic electroluminescent device according to claim 8, wherein the light emitting layer includes a blue light emitting dopant, which is a pyrene derivative.

10. The organic electroluminescent device according to any one of claims 1 to 9, wherein the light emitting layer includes an anthracene derivative.

11. The organic electroluminescent device according to claim 10, wherein the light emitting layer includes a host material which is an anthracene derivative.

12. An organic electroluminescent device comprising an anode, a hole transport layer, an electron blocking layer, a light emitting layer, an electron transport layer, and a cathode in this order, wherein the electron blocking layer comprises an arylamine compound of the following general formula (1): 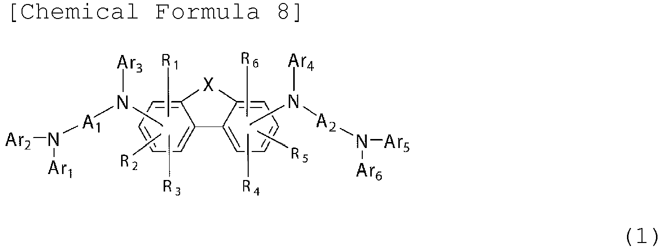 wherein Ar₁ to Ar₆ may be the same or different, and represent a substituted or unsubstituted aromatic hydrocarbon group, a substituted or unsubstituted aromatic heterocyclic group, or a substituted or unsubstituted condensed polycyclic aromatic group, and A₁ and A₂ may be the same or different, and represent a divalent group of a substituted or unsubstituted aromatic hydrocarbon, a divalent group of a substituted or unsubstituted aromatic heterocyclic ring, a divalent group of a substituted or unsubstituted condensed polycyclic aromatic, and R₁ to R₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy, and X represents an oxygen atom or a sulfur atom.

13. An organic electroluminescent device comprising an anode, a hole injection layer, a hole transport layer, a light emitting layer, an electron transport layer, and a cathode in this order, wherein the hole injection layer comprises an arylamine compound of the following general formula (1): 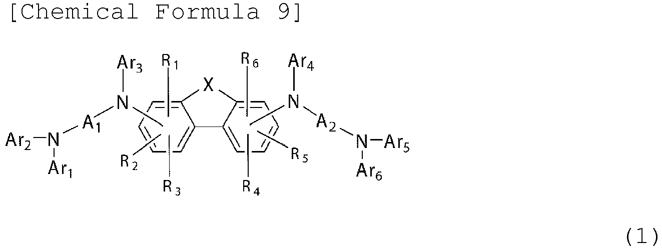 wherein Ar₁ to Ar₆ may be the same or different, and represent a substituted or unsubstituted aromatic hydrocarbon group, a substituted or unsubstituted aromatic heterocyclic group, or a substituted or unsubstituted condensed polycyclic aromatic group, and A₁ and A₂ may be the same or different, and represent a divalent group of a substituted or unsubstituted aromatic hydrocarbon, a divalent group of a substituted or unsubstituted aromatic heterocyclic ring, a divalent group of a substituted or unsubstituted condensed polycyclic aromatic, and R₁ to R₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy, and X represents an oxygen atom or a sulfur atom.

14. An organic electroluminescent device comprising an anode, a hole transport layer, a light emitting layer, an electron transport layer, and a cathode in this order, wherein the light emitting layer comprises an arylamine compound of the following general formula (1): 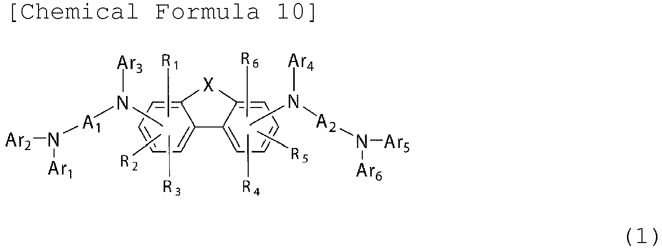 wherein Ar₁ to Ar₆ may be the same or different, and represent a substituted or unsubstituted aromatic hydrocarbon group, a substituted or unsubstituted aromatic heterocyclic group, or a substituted or unsubstituted condensed polycyclic aromatic group, and A₁ and A₂ may be the same or different, and represent a divalent group of a substituted or unsubstituted aromatic hydrocarbon, a divalent group of a substituted or unsubstituted aromatic heterocyclic ring, a divalent group of a substituted or unsubstituted condensed polycyclic aromatic, and R₁ to R₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy, and X represents an oxygen atom or a sulfur atom.
